# EUROPÄISCHE PATENTSCHRIFT

(11) **EP 4 063 818 B1**
(45) Veröffentlichungstag und Bekanntmachung des Hinweises auf die Patenterteilung: **30.10.2024**
(21) Anmeldenummer: 22159696.8
(22) Anmeldetag: 02.03.2022
(51) Int. Cl.: G01L 1/16, G01P 15/09, G01P 1/02, G01P 15/18, G01L 19/00, G01L 19/14, G01L 23/10

(54) **PIEZOELEKTRISCHER BESCHLEUNIGUNGSAUFNEHMER**
PIEZOELECTRIC ACCELERATION TRANSDUCER
CAPTEUR D'ACCÉLÉRATION PIÉZOÉLECTRIQUE

(30) Priorität: 22.03.2021 EP 21164057
(43) Veröffentlichungstag der Anmeldung: 28.09.2022
(73) Patentinhaber: Kistler Holding AG, 8408 Winterthur (CH)
(72) Erfinder: Frommenwiler, Tobias, 8406 Winterthur (CH); Laffranchi, Marco, 8408 Winterthur (CH); Weber, David, 8472 Seuzach (CH); Wyss, Andreas, 8050 Zürich (CH)

(56) Entgegenhaltungen:
- EP-A1- 2 703 825
- EP-A1- 2 843 385
- EP-A2- 3 124 947
- WO-A1-2007/128149
- WO-A1-2017/093100
- DE-A1- 102012 108 254

## Beschreibung

### Technisches Gebiet

Die Erfindung betrifft einen piezoelektrischen Beschleunigungsaufnehmer nach dem Oberbegriff des unabhängigen Anspruches.

### Stand der Technik

Die Schrift CH392103A1 offenbart einen piezoelektrischen Aufnehmer in der Verwendung als piezoelektrischen Druckaufnehmer. Dieser weist mindestens ein Piezoelement aus piezoelektrischem Material auf. Unter der Wirkung einer aufzunehmenden Messgrösse erzeugt das Piezoelement Polarisationsladungen. Die Anzahl der erzeugten Polarisationsladungen ist proportional zum Wert der Messgrösse. Die Polarisationsladungen werden von Elektroden abgegriffen und als Signal abgeleitet.

Das Piezoelement ist empfindlich und lässt sich leicht durch Umgebungseinflüsse wie Verunreinigungen (Staub, Feuchtigkeit, usw.) dauerhaft beschädigen. Deshalb weist der piezoelektrische Aufnehmer ein Gehäuse aus mechanisch beständigem Material auf. Das Piezoelement und die Elektroden sind im Inneren des Gehäuses wasser- und gasdicht angeordnet.

Der piezoelektrische Aufnehmer weist auch eine Signaldurchführung auf. Die Signaldurchführung ist mechanisch am Gehäuse befestigt und leitet das Signal aus dem Inneren des Gehäuses nach aussen ab. Dazu weist die Signaldurchführung mindestens einen Durchgangsleiter auf, der elektrisch gegenüber dem Gehäuse isoliert ist. Im Inneren des Gehäuses ist der Durchgangsleiter mit mindestens einer Elektrode elektrisch verbunden. Ausserhalb des Gehäuses ist der Durchgangsleiter mit mindestens einem Signalleiter eines Signalkabels elektrisch verbindbar.

Ein solcher piezoelektrischer Aufnehmer lässt sich vielfältig verwenden. So misst ein piezoelektrischer Druckaufnehmer den Druck in der Brennkammer eines Verbrennungsmotors. Oder ein piezoelektrischer Kraft- und Momentenaufnehmer misst die Fügekraft beim Fügen von Bauteilen. Und ein piezoelektrischer Beschleunigungsaufnehmer misst Beschleunigungen und Vibrationen eines Gegenstandes, an dem er befestigt ist. Diese vielfältigen Verwendungen haben die Gemeinsamkeit, dass der piezoelektrische Aufnehmer möglichst klein bauen muss und möglichst leicht sein soll.
Die Schrift EP3124947A2 bezieht sich auf einen piezoelektrischer Druckaufnehmer mit einer Sensoranordnung und einer Auswerteeinheit auf. Die Auswerteeinheit ist direkt mit der Sensoranordnung elektrisch und mechanisch verbunden. Die Sensoranordnung umfasst ein Piezoelement und Elektroden zum Abgreifen der unter der Wirkung des Druckverlaufs erzeugten Polarisationsladungen. Die Auswerteeinheit weist eine elektrische Leiterplatte auf, welche in einen der Sensoranordnung zugewandten Hochtemperaturbereich und in einen von der Sensoranordnung abgewandten Normaltemperaturbereich unterteilt ist. Elektronische Komponenten zur Auswertung der Polarisationsladungen sind im Normaltemperaturbereich bestückt.
Die Schrift WO2007128149A1 lehrt einen piezoelektrischen Kraftaufnehmer mit piezoelektrischen Stäben nach dem Transversaleffekt. Unter Krafteinwirkung werden auf Mantelflächen der piezoelektrische Stäbe Oberflächenladungen erzeugt. Auf den Mantelflächen angebrachte Metallisierungen greifen die Oberflächenladungen ab und leiten sie zu zwei Elektroden auf einer Stirnfläche der piezoelektrischen Stäbe. Jede Elektrode ist elektrisch mit einer Kontaktierung verbunden. Die beiden Kontaktierungen reichen durch eine Abdeckung nach ausserhalb des piezoelektrischen Kraftaufnehmers für eine elektrische Verbindung zu einer zweiadrigen Messsignalleitung.
Die Schrift WO2017093100A1 offenbart einen Beschleunigungssensor mit einem piezoelektrischen System und einer elektrischen Masse. Bei Beschleunigung übt die seismische Masse eine zu ihrer Beschleunigung proportionale Kraft auf das piezoelektrische System aus, welche Kraft im piezoelektrischen System elektrische Ladungen erzeugt. Die seismische Masse ist in ein erstes und ein zweites Masseelement geteilt. Die beiden Masseelemente sind mittels einer elektrischen Isolation gegeneinander elektrisch isoliert. Am ersten Masseelement sind positive elektrische Ladungen abgreifbar und am zweiten Masseelement sind negative elektrische Ladungen abgreifbar.
Auch die Schrift EP2703825A1 zeigt einen Beschleunigungssensor mit einem piezoelektrischen Aufnehmer und einer elektrischen Masse. Der piezoelektrische Aufnehmer weist mehrere piezoelektrische Scheiben auf. Unter der Wirkung der Beschleunigung über die seismische Masse eine Kraft auf den piezoelektrischen Aufnehmer aus, welche Kraft auf den piezoelektrischen Scheiben positive und negative Ladungen erzeugt. Die positiven Ladungen werden von positiven Elektroden abgegriffen, die negativen Ladungen werden von negativen Elektroden abgegriffen. Der Beschleunigungssensor weist ein Gehäuse und zwei Durchführungen auf. Je eine der beiden Durchführungen ist elektrisch mit einer der positiven und negativen Elektroden verbunden und leiten die positiven und negativen Ladungen durch das Gehäuse nach ausserhalb des Beschleunigungssensors ab.
Eine erste Aufgabe der vorliegenden Erfindung ist es, einen piezoelektrischen Beschleunigungsaufnehmer mit kleinen äusseren Abmessungen und geringem Gewicht bereitzustellen. Und als zweite Aufgabe der Erfindung soll der piezoelektrische Beschleunigungsaufnehmer kostengünstig herstellbar sein.

### Darstellung der Erfindung

Zumindest eine dieser Aufgaben wird durch die Merkmale des unabhängigen Anspruches gelöst.

Die Erfindung betrifft einen piezoelektrischen Beschleunigungsaufnehmer zum Messen einer Beschleunigung; mit einer Aufnehmereinheit, welche mindestens ein Piezoelement und mindestens zwei Elektroden aufweist, welches Piezoelement aus piezoelektrischem Material ist und unter der Wirkung der Beschleunigung Polarisationsladungen erzeugt, welche Elektroden das Piezoelement bereichsweise direkt kontaktieren und die Polarisationsladungen abgreifen; mit einem Gehäuse, welches die Aufnehmereinheit wasser- und gasdicht umschliesst; und mit einer Signaldurchführung, welche mit den Elektroden elektrisch verbunden ist und die Polarisationsladungen als Signale durch das Gehäuse zu einer Umgebung ausserhalb des Gehäuses ableitet; wobei der piezoelektrische Aufnehmer ein Signalkabel aufweist, welches in der Umgebung ausserhalb des Gehäuses angeordnet ist und welches mindestens zwei Signalleiter aufweist; wobei die Signaldurchführung ein Trägerelement aufweist, auf welchem Trägerelement mindestens zwei Leiterbahnen angeordnet sind; und wobei je einer der Signalleiter genau eine der Leiterbahnen kontaktiert.

Das Trägerelement ist ein mechanischer Träger für Leiterbahnen, auf welchen Leiterbahnen die Signalleiter des Signalkabels kontaktieren. Das Trägerelement und die Leiterbahnen sind in sehr kleinen äusseren Abmessungen ausführbar. Dennoch sind die Leiterbahnen auf dem Trägerelement zum Kontaktieren der Signalleiter gut zugänglich.

Die abhängigen Ansprüche beziehen sich auf weitere vorteilhafte Ausführungsformen der Erfindung.

So beziehen sich die unabhängigen Ansprüche 11 und 14 auf ein Verfahren zur Montage des piezoelektrischen Beschleunigungsaufnehmers.

### Kurze Beschreibung der Zeichnungen

Im Folgenden wird die Erfindung beispielhaft unter Beizug der Figuren näher erklärt. Es zeigen
- Fig. 1: schematisch einen Schnitt durch einen Teil einer ersten Ausführungsform eines piezoelektrischen Aufnehmers 1;
- Fig. 2: schematisch einen Schnitt durch einen Teil einer zweiten Ausführungsform eines piezoelektrischen Aufnehmers 1, die nicht in den Schutzbereich der Ansprüche fällt;
- Fig. 3: schematisch einen Schnitt durch einen Teil einer dritten Ausführungsform eines piezoelektrischen Aufnehmers 1;
- Fig. 4: schematisch eine Ansicht von oben einer ersten Ausführungsform eines Trägerelementes 13.1 des piezoelektrischen Aufnehmers 1 nach Fig. 1;
- Fig. 5: schematisch eine Ansicht von unten der ersten Ausführungsform des Trägerelementes 13.1 nach Fig. 3;
- Fig. 6: schematisch eine Ansicht von oben einer zweiten Ausführungsform eines Trägerelementes 13.1 des piezoelektrischen Aufnehmers 1 nach Fig. 2;
- Fig. 7: schematisch eine Ansicht von unten der zweiten Ausführungsform des Trägerelementes 13.1 nach Fig. 5;
- Fig. 8: schematisch eine Ansicht einer dritten Ausführungsform eines Trägerelementes 13.1 des piezoelektrischen Aufnehmers 1 nach Fig. 3;
- Fig. 9: schematisch eine Ansicht eines ersten Schrittes bei der Montage des piezoelektrischen Aufnehmers 1 in der ersten Ausführungsform nach Fig. 1 mit dem Bereitstellen einer Signaldurchführung 13 mit einer Signaldurchführungswand 13.3 und eines Signalkabels 14 und dem Einschieben von Enden des Signalkabels 14 in eine Signalleiteröffnung 13.4 der Signaldurchführungswand 13.3;
- Fig. 10: schematisch eine Ansicht eines zweiten Schrittes bei der Montage nach Fig. 9 mit dem Kontaktieren von Signalleitern 14.11 - 14.14 des Signalkabels 14 mit dem Trägerelement 13.1 in der ersten Ausführungsform nach Fig. 4 und 5;
- Fig. 11: schematisch eine Ansicht eines dritten Schrittes bei der Montage nach Fig. 9 und 10 mit dem Einsetzen des Trägerelementes 13.1 in der Signaldurchführungswand 13.3;
- Fig. 12: schematisch eine Ansicht eines vierten Schrittes bei der Montage nach Fig. 9 bis 11 mit dem Vergiessen des Trägerelementes 13.1 in der Signaldurchführungswand 13.3;
- Fig. 13: schematisch eine Ansicht eines fünften Schrittes bei der Montage nach Fig. 9 bis 12 mit dem Bereitstellen von Teilen eines Gehäuses 12 und dem Verbinden der Teile des Gehäuses 12 mit der Signaldurchführungswand 13.3;
- Fig. 14: schematisch eine Ansicht eines sechsten Schrittes bei der Montage nach Fig. 9 bis 13 mit dem Bereitstellen einer Aufnehmereinheit 11 und dem Befestigen der Aufnehmereinheit 11 im Gehäuse 12;
- Fig. 15: schematisch eine Ansicht eines siebten Schrittes bei der Montage nach Fig. 9 bis 14 mit dem Kontaktieren von Verbindungsleitern 13.31 - 13.34 mit dem Trägerelement 13.1 und der Aufnehmereinheit 11;
- Fig. 16: schematisch einen vergrösserten Ausschnitt von Fig. 15 mit Verbindungsleiter-Kontaktstellen 13.4113.44 auf dem Trägerelement 13.1 mit Aufnehmereinheit-Kontaktflächen 11.81 - 11.84 auf der Aufnehmereinheit 11 zum Kontaktieren der Verbindungsleiter 13.31 - 13.34;
- Fig. 17: schematisch ein Ansicht eines achten Schrittes bei der Montage nach Fig. 9 bis 15 nach dem Verschliessen der Gehäuseöffnung mit einem Gehäusedeckel 12.3;
- Fig. 18: schematisch eine Ansicht bei der Montage des piezoelektrischen Aufnehmers 1 in der Ausführungsform nach Fig. 3, mit in einem ersten Schritt dem Bereitstellen von Teilen eines Gehäuses 12, einer Signaldurchführung 13 und eines Trägerelementes 13.1 in der Ausführungsform nach Fig. 8 und in einem zweiten Schritt mit dem Verbinden der Teile des Gehäuses 12 mit der Signaldurchführungswand 13.3 und dem Befestigen des Trägerelementes 13.1 an einer Signaldurchführungswand 13.3 der Signaldurchführung 13;
- Fig. 19: schematisch eine Ansicht bei der Montage nach Fig. 18, mit in einem dritten Schritt dem Bereitstellen eines Signalkabels 14 mit Signalleitern 14.1114.14 und dem Einschieben der Enden der Signalleiter 14.11 - 14.14 in eine Signalleiteröffnung 13.4 der Signaldurchführungswand 13.3 und eine Durchgangsöffnung 13.4' des Trägerelementes 13.1 und in einem vierten Schritt dem Kontaktieren der Signalleiter 14.11 - 14.14 mit SignalleiterKontaktflächen 13.131 - 13.134 des Trägerelementes 13.1;
- Fig. 20: schematisch eine Ansicht eines fünften Schrittes bei der Montage nach Fig. 18 und 19 mit dem Vergiessen der Signalleiteröffnung 13.4' des Trägerelementes 13.1;
- Fig. 21: schematisch eine Ansicht bei der Montage nach Fig. 18 bis 20, mit in einem sechsten Schritt dem Bereitstellen einer Aufnehmereinheit 11 und dem Befestigen der Aufnehmereinheit 11 im Gehäuse 12 und mit in einem siebten Schritt dem Kontaktieren von Verbindungsleitern 13.31 - 13.34 mit dem Trägerelement 13.1 und der Aufnehmereinheit 11; und
- Fig. 22: schematisch ein Ansicht eines achten Schrittes bei der Montage nach Fig. 18 bis 21 nach dem Verschliessen der Gehäuseöffnung mit einem Gehäusedeckel 12.3.

Gleiche Bezugszeichen bezeichnen in den Figuren gleiche Gegenstände.

### Wege zur Ausführung der Erfindung

Der piezoelektrische Aufnehmer 1 weist eine Aufnehmereinheit 11, ein Gehäuse 12, eine Signaldurchführung 13 und ein Signalkabel 14 auf. Zur Orientierung ist der piezoelektrische Aufnehmer 1 in einem rechtwinkligen Koordinatensystem mit drei Achsen x, y, z angeordnet, welche als Querachse x, Längsachse y und Vertikalachse z bezeichnet werden.

### DIE AUFNEHMEREINHEIT

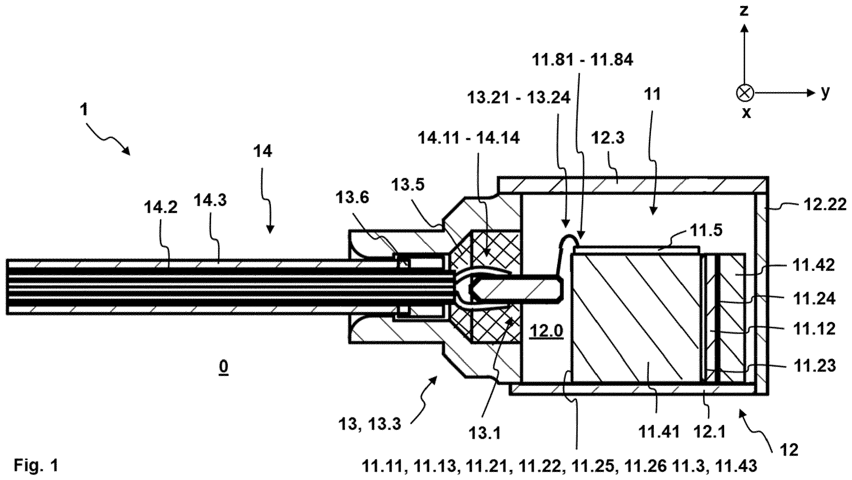

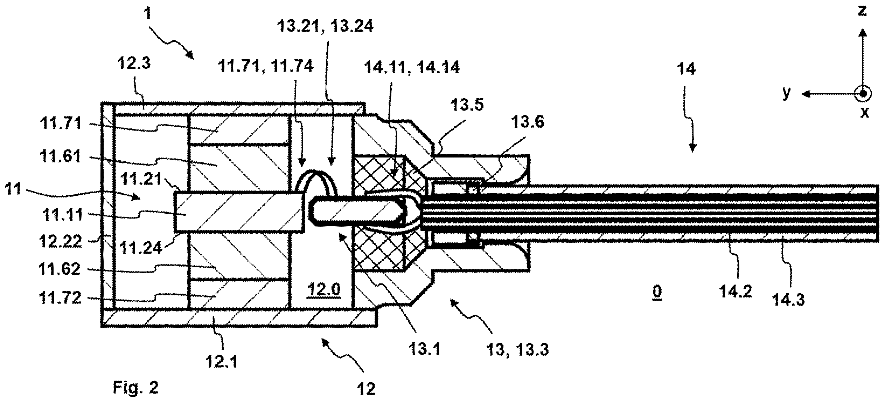

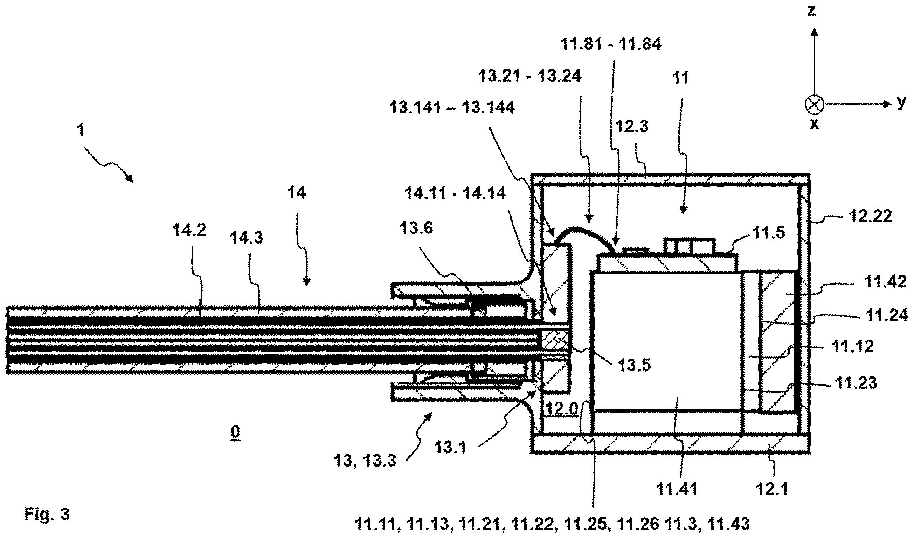

Die Fig. 1 bis 3 zeigen drei Ausführungsformen des piezoelektrischen Aufnehmers 1. In den beiden Ausführungsformen nach Fig. 1 und 3 nimmt der piezoelektrischen Aufnehmer 1 als Messgrösse Beschleunigungen auf. In der Ausführungsform nach Fig. 2, die nicht Bestandteil der vorliegenden Erfindung ist, nimmt der piezoelektrischen Aufnehmer 1 als Messgrösse Drucke oder Kräfte oder Momente auf.

Die Aufnehmereinheit 11 weist mindestens ein Piezoelement 11.11 - 11.13 aus piezoelektrischem Material auf. Beispiele für das piezoelektrische Material sind Quarz (SiO₂ Einkristall), Calcium-Gallo- Germanat (Ca₃Ga₂Ge₄O₁₄ oder CGG), Langasit (La₃Ga₅SiO₁₄ oder LGS), Turmalin, Galliumorthophosphat, Piezokeramik, usw.

In den beiden Ausführungsformen des piezoelektrischen Aufnehmers 1 nach Fig. 1 und 3 weist die Aufnehmereinheit 11 drei Piezoelemente 11.11 - 11.13 auf, nämlich ein erstes Piezoelement 11.11, ein zweites Piezoelement 11.12 und ein drittes Piezoelement 11.13. Jedes der Piezoelemente 11.11 - 11.13 ist im Querschnitt rechteckig.

In der Ausführungsform des piezoelektrischen Aufnehmers 1 nach Fig. 2, die nicht in den Schutzbereich der Ansprüche fällt, weist die Aufnehmereinheit 11 ein Piezoelement 11.11 auf. Das Piezoelement 11.11 ist im Querschnitt scheibenförmig.

Die Aufnehmereinheit 11 weist mindestens zwei Elektroden 11.21 - 11.26 auf. Die Elektroden 11.21 - 11.26 sind aus elektrisch leitfähigem Material. Beispiele für das elektrisch leitfähige Material sind Kupfer, Kupferlegierungen, Gold, Goldlegierungen, Aluminium, Aluminiumlegierungen, usw. Unter der Wirkung einer zu messenden Messgrösse erzeugt das Piezoelement 11.11 - 11.13 Polarisationsladungen. Die Polarisationsladungen werden von den Elektroden 11.21 - 11.26 abgegriffen. Je eine der Elektroden 11.21 - 11.26 kontaktiert eine von zwei gegenüberliegenden Oberflächen des Piezoelementes 11.11 - 11.13 bereichsweise direkt. Im Sinne der Erfindung wird mit dem Verb "kontaktieren" die Bereitstellung einer elektrischen und mechanischen Verbindung bezeichnet. Und das Adjektiv "direkt" hat die Bedeutung von "unmittelbar". Vorzugsweise haben die Elektroden 11.21 - 11.26 eine Dicke von kleiner/gleich 0.1mm. Die Elektroden 11.21 - 11.26 bestehen aus thermokaschierten Folien, Metallabscheidung, usw.

Die Aufnehmereinheit 11 weist mindestens eine ersten Elektrode 11.21 - 11.23 und mindestens eine weitere Elektrode 11.24 - 11.26 auf.

In den beiden Ausführungsformen des piezoelektrischen Aufnehmers 1 nach Fig. 1 und 3 weist die Aufnehmereinheit 11 drei erste Elektroden 11.21 - 11.23 und drei weitere Elektroden 11.24 - 11.26 auf. Jede der drei ersten Elektroden 11.21 - 11.23 greift Polarisationsladungen vom Piezoelement 11.11 - 11.13 ab und liefert eines von drei ersten Signalen S1 - S3. Jede weitere Elektrode 11.24 - 11.26 greift Polarisationsladungen vom Piezoelement 11.11 - 11.13 ab. Die weiteren Elektroden 11.24 - 11.26 sind elektrisch kurzgeschlossen und bilden so eine gemeinsame Signalmasse. Die Signalmasse S4 wird als weiteres Signal S4 geliefert.

In der Ausführungsform des piezoelektrischen Aufnehmers 1 nach Fig. 2, die nicht in den Schutzbereich der Ansprüche fällt, weist die Aufnehmereinheit 11 eine erste Elektrode 11.21 und eine weitere Elektrode 11.24 auf. Die erste Elektrode 11.21 greift Polarisationsladungen vom Piezoelement 11.11 ab und liefert ein Signal S1. Die weitere Elektrode 11.24 greift Polarisationsladungen vom Piezoelement 11.11 ab und liefert ein weiteres Signal S4.

In den beiden Ausführungsformen des piezoelektrischen Aufnehmers 1 nach Fig. 1 und 3 weist die Aufnehmereinheit 11 einen Grundkörper 11.3 auf. Der Grundkörper 11.3 ist vorzugsweise aus mechanisch steifem Material von geringer Dichte wie Al₂O₃, Keramik, Al₂O₃-Keramik, Saphir, usw. Der Grundkörper 11.3 ist vorzugsweise ein Kubus mit sechs Seitenflächen. Über den Grundkörper 11.3 ist die Aufnehmereinheit 11 am Gehäuseboden 12.1 befestigt.

In den beiden Ausführungsformen des piezoelektrischen Aufnehmers 1 nach Fig. 1 und 3 weist die Aufnehmereinheit 11 drei seismische Massen 11.41 - 11.43 auf. Die seismischen Massen 11.41 - 11.43 sind vorzugsweise aus Material von hoher Dichte wie Iridium, Platin, Wolfram, Gold, usw. Jede seismische Masse 11.41 - 11.43 ist im Querschnitt rechteckig. Eine erste seismische Masse 11.41 und das erste Piezoelement 11.1 sind an einer ersten Seitenfläche des Grundkörpers 11.3 befestigt. Eine zweite seismische Masse 11.42 und das zweite Piezoelement 11.12 sind an einer zweiten Seitenfläche des Grundkörpers 11.3 befestigt. Eine dritte seismische Masse 11.43 und das dritte Piezoelement 10.13 sind an einer dritten Seitenfläche des Grundkörpers 11.3 befestigt. Dabei ist ein Piezoelement 11.11 - 11.13 jeweils zwischen einer der Seitenflächen und einer seismischen Masse 11.41 - 11.43 angeordnet.

In den beiden Ausführungsformen des piezoelektrischen Aufnehmers 1 nach Fig. 1 und 3 weist die Aufnehmereinheit 11 mindestens eine Wandlereinheit 11.5 auf. Die Wandlereinheit 11.5 ist eine elektrische Schaltung und wandelt mindestens die ersten Signale S1 - S3. Die Wandlung der ersten Signale S1 - S3 umfasst mindestens eine der folgenden Handlungen: eine elektrische Wandlung der ersten Signale S1 - S3 in eine elektrische Spannung, eine elektrische Verstärkung der ersten Signale S1 - S3, eine Digitalisierung der ersten Signale S1 - S3. Die Wandlereinheit 11.5 ist auf einer der sechs Seitenflächen des Grundkörpers 11.3 befestigt.

Die Aufnehmereinheit 11 weist mindestens zwei Aufnehmereinheit-Kontaktflächen 11.81 - 11.84 auf. An den Aufnehmereinheit-Kontaktflächen 11.81 - 11.84 liegen Signale S1 - S4 an.

In den beiden Ausführungsformen des piezoelektrischen Aufnehmers 1 nach Fig. 1 und 3 weist die Wandlereinheit 11.5 der Aufnehmereinheit 11 drei erste Aufnehmereinheit-Kontaktflächen 11.81 - 11.83 und eine weitere Aufnehmereinheit-Kontaktfläche 11.84 auf. An den drei ersten Aufnehmereinheit-Kontaktflächen 11.81 - 11.83 liegen erste Signale S1 - S3 als gewandelte erste Signale S1 - S3 an, an der weiteren Aufnehmereinheit-Kontaktfläche 11.84 liegt das weitere Signal S4 an.

In der Ausführungsform des piezoelektrischen Aufnehmers 1 nach Fig. 2, die nicht in den Schutzbereich der Ansprüche fällt, weist die erste Elektrode 11.21 der Aufnehmereinheit 11 eine erste Aufnehmereinheit-Kontaktfläche 11.81 auf und die weitere Elektrode 11.24 der Aufnehmereinheit 11 weist eine weitere Aufnehmereinheit-Kontaktfläche 11.84 auf. An der ersten Aufnehmereinheit-Kontaktfläche 11.81 liegt das erste Signal S1 an, an der weiteren Aufnehmereinheit-Kontaktfläche 11.84 liegt das weitere Signal S4 an.

In der Ausführungsform des piezoelektrischen Aufnehmers 1 nach Fig. 2, die nicht in den Schutzbereich der Ansprüche fällt, weist die Aufnehmereinheit 1 ein erstes Isolationselement 11.61 und ein zweites Isolationselement 11.62. Die Isolationselemente 11.61, 11.62 sind vorzugsweise aus mechanisch steifem Material von geringer Dichte wie Al₂O₃, Keramik, Al₂O₃-Keramik, Saphir, usw. Die Isolationselemente 11.61, 11.62 sind vorzugsweise zylinderförmig. Bezüglich der Vertikalachse z liegt je eines der Isolationselemente 11.61, 11.62 aussenseitig an einer der Elektroden 11.21, 11.24 an. Die Isolationselemente 11.61, 11.62 dienen der elektrischen Isolation des Piezoelementes 11.11 und der Elektroden 11.21, 11.24 gegenüber dem Gehäuse 12.

In der Ausführungsform des piezoelektrischen Aufnehmers 1 nach Fig. 2, die nicht in den Schutzbereich der Ansprüche fällt, weist die Aufnehmereinheit 11 ein erstes Kompensationselement 11.71 und ein zweites Kompensationselement 11.72 auf. Die Kompensationselemente 11.71, 11.72 sind vorzugsweise aus mechanisch steifem Material wie aus Reinmetallen, Nickellegierungen, Kobaltlegierungen, Eisenlegierungen, usw. Die Kompensationselemente 11.71, 11.72 dienen der Kompensation von unterschiedlichen Wärmeausdehnungskoeffizienten des Piezoelementes 11.11, der Elektroden 11.21, 11.24 und dem Gehäuse 12. Die Kompensationselemente 11.71, 11.72 sind vorzugsweise zylinderförmig. Bezüglich der Vertikalachse z liegt je eines der Kompensationselemente 11.71, 11.72 aussenseitig an einem der Isolationselemente 11.61, 11.62 an. Über die Kompensationselemente 11.71, 11.72 ist die Aufnehmereinheit 11 am Gehäuse 12 befestigt.

### DAS GEHÄUSE

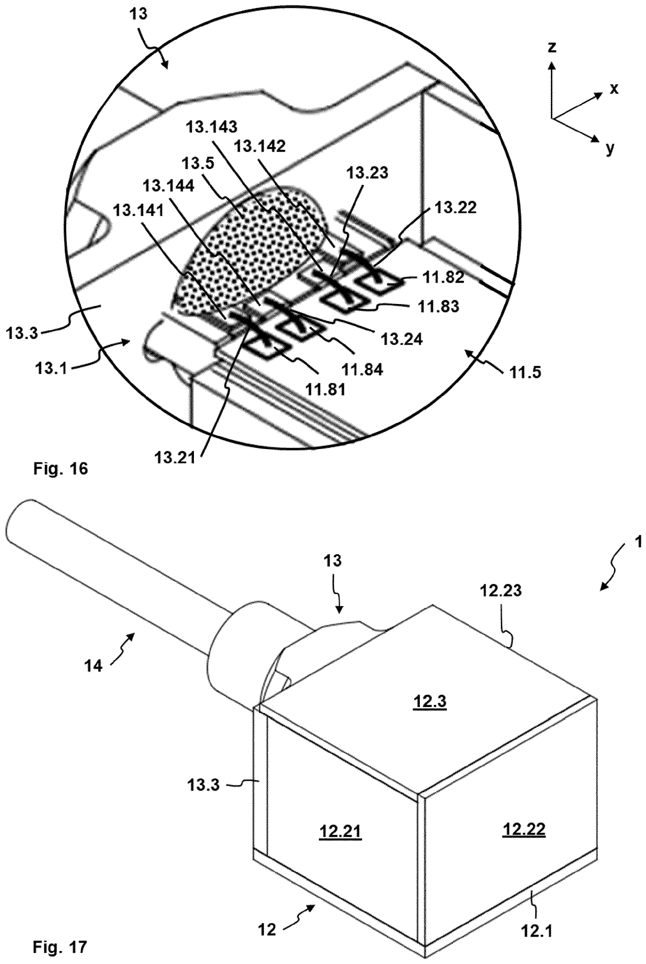

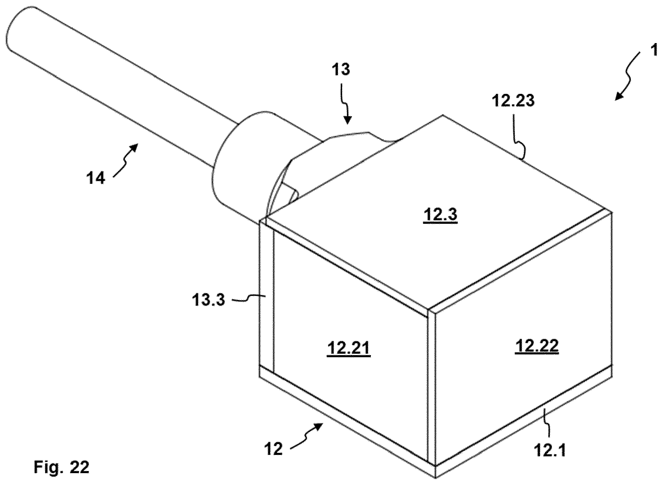

Das Gehäuse 12 schützt die Aufnehmereinheit 11 vor schädlichen Umgebungseinflüssen wie Verunreinigungen (Staub, Feuchtigkeit, usw.), aber auch vor elektrischen und elektromagnetischen Störeffekten in Form von elektromagnetischer Strahlung aus einer Umgebung. Das Gehäuse 12 ist aus mechanisch beständigem Material wie aus Reinmetallen, Nickellegierungen, Kobaltlegierungen, Eisenlegierungen, usw. Das Gehäuse 12 ist ein Hohlkörper mit einem Gehäuseinneren 12.0. Vorzugsweise weist das Gehäuse 12 als Teile einen Gehäuseboden 12.1, mindestens eine Gehäusewand 12.21 - 12.23 und einen Gehäusedeckel 12.3 auf. Vorzugsweise weist das Gehäuse 12 drei Gehäusewände 12.21 - 12.23 auf, nämlich eine erste Gehäusewand 12.21, eine zweite Gehäusewand 12.22 und eine dritte Gehäusewand 12.23. In den Schnitten nach Fig. 1 bis 3 ist nur die zweite Gehäusewand 12.22 dargestellt. Doch in den Ansichten nach Fig. 17 und 22 sind alle drei Gehäusewände 12.21 - 12.23 dargestellt. Die Teile des Gehäuses 12 sind durch Stoffschluss wie Schweissen, Löten, Kleben, usw. mechanisch stabil miteinander verbunden. In den drei Ausführungsformen nach Fig. 1 bis 3 ist das Gehäuse 12 quaderförmig und weist sechs Seitenwände auf. Von den sechs Seitenwänden werden fünf Seitenwände durch den Gehäuseboden 12.1, die drei Gehäusewände 12.21 - 12,23 und den Gehäusedeckel 12.3 gebildet. Die sechste Seitenwand wird durch eine Signaldurchführungswand 13.3 der Signaldurchführung 13 gebildet.

Das Gehäuseinnere 12.0 ist so gross bemessen, dass die Aufnehmereinheit 11 darin vollständig Platz hat. Die Aufnehmereinheit 11 ist durch eine Gehäuseöffnung in das Gehäuseinnere 12.0 einsetzbar. Die Gehäuseöffnung ist durch den Gehäusedeckel 12.3 verschliessbar. Vorzugsweise ist das Gehäuse 12 geerdet. Der über das Gehäuse 12 geerdete piezoelektrische Aufnehmer 1 liegt auf einem elektrischen Potenzial des lokalen Erdreichs. Das Gehäuse 12 bildet so einen Faraday'schen Käfig gegenüber elektromagnetischer Strahlung aus der Umgebung 0.

### DIE SIGNALDURCHFÜHRUNG

Die Signaldurchführungswand 13.3 ist aus mechanisch beständigem Material wie aus Reinmetallen, Nickellegierungen, Kobaltlegierungen, Eisenlegierungen, usw. Die Signaldurchführungswand 13.3 ist mit dem Gehäuse 12 durch Stoffschluss wie Schweissen, Löten, Kleben, usw. mit dem Gehäuse 12 mechanisch stabil verbunden. Die Signaldurchführungswand 13.3 weist eine erste Seite und eine zweite Seite auf. Im mechanisch stabil mit dem Gehäuse 12 verbundenen Zustand der Signaldurchführungswand 13.3 begrenzt die erste Seite den piezoelektrischen Aufnehmer 1 bezüglich der Umgebung 0 und die zweite Seite begrenzt das Gehäuseinnere 12.0. Die Umgebung 0 befindet sich ausserhalb des Gehäuses 12. Das Gehäuse 12 und die mit ihm mechanisch stabil verbundene Signaldurchführungswand 13.3 umschliessen die Aufnehmereinheit 11 gegenüber der Umgebung 0 wasser- und gasdicht. Dabei hält das Gehäuse 12 einen Druck des Wassers oder Gases von mindestens 3bar aus.

Die Signaldurchführungswand 13.3 weist eine Signalleiteröffnung 13.4 auf. Die Signalleiteröffnung 13.4 reicht durch die Signaldurchführungswand 13.3 von der ersten Seite bis zur zweiten Seite. Vorzugsweise weist die Signalleiteröffnung 13.4 einen Querschnitt auf, welcher demjenigen des Signalkabels 14 entspricht. Enden der Signalleiter 14.11 - 14.14 ragen durch die Signalleiteröffnung 13.4 in das Gehäuseinnere 12.0.

Die Signaldurchführung 13 weist einen Signaldurchführungsflansch 13.6 auf. Der Signaldurchführungsflansch 13.6 begrenzt die Signalleiteröffnung 13.4 einseitig. Vorzugsweise ist ein Ende des Schutzmantels 14.3 mit dem Signaldurchführungsflansch 13.6 verbunden. Die Verbindung von Schutzmantel 14.3 und Signaldurchführungsflansch 13.6 erfolgt durch Kraftschluss wie Crimpen, usw. Die Verbindung von Schutzmantel 14.3 und Signaldurchführungsflansch 13.6 ist gegenüber der Umgebung 0 wasser- und gasdicht. Die Verbindung von Schutzmantel 14.3 und Signaldurchführungsflansch 13.6 bewirkt eine Zugentlastung des Schutzmantels 14.3. Aufgrund der Zugentlastung des Schutzmantels 14.3 können mechanische Belastungen vom Schutzmantel 14.3 nicht in das Gehäuseinnere 12.0 übertragen werden und dort zu Beschädigungen wie ein Abreissen oder Anreissen von Verbindungsleitern 13.21 - 13.24 führen. Solche mechanische Belastungen stammen von Verdrehungen, Verzwirbelungen, usw. des Schutzmantels 14.3 um dessen längliche Ausdehnungsachse.

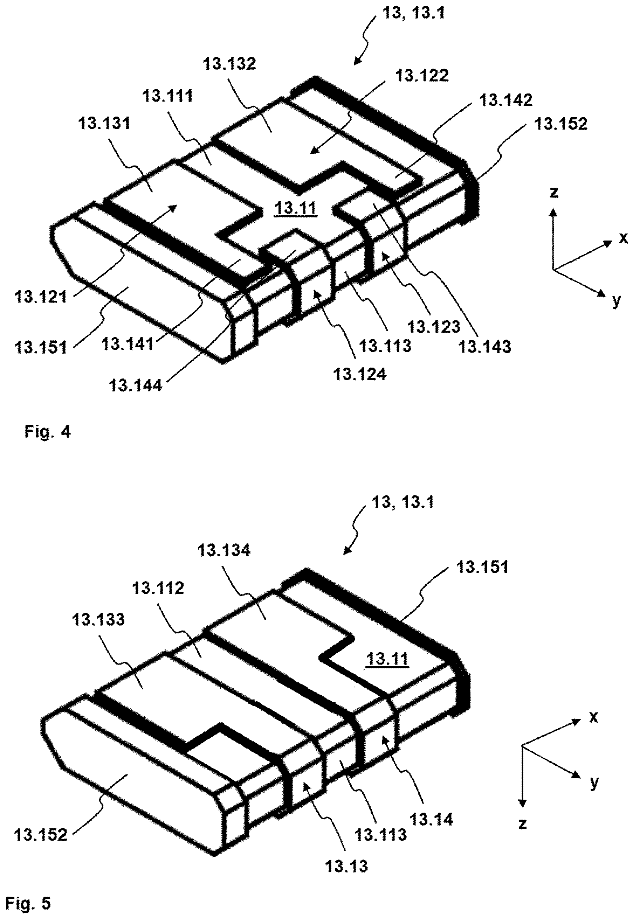

Die Signaldurchführung 13 weist ein Trägerelement 13.1 auf. Die Fig. 4 bis 8 zeigen drei Ausführungsformen des Trägerelementes 13.1.

In den beiden Ausführungsformen nach Fig. 4 bis 7 weist das Trägerelement 13.1 vorzugsweise eine grösste axiale Ausdehnung entlang der Querachse x auf, welche weitgehend dem Querschnitt des Signalkabels 14 entspricht. Entlang der Längsachse y weist das Trägerelement 13.1 eine zweitgrösste axiale Ausdehnung auf. Entlang der Vertikalachse z weist das Trägerelement 13.1 eine kleinste axiale Ausdehnung auf.

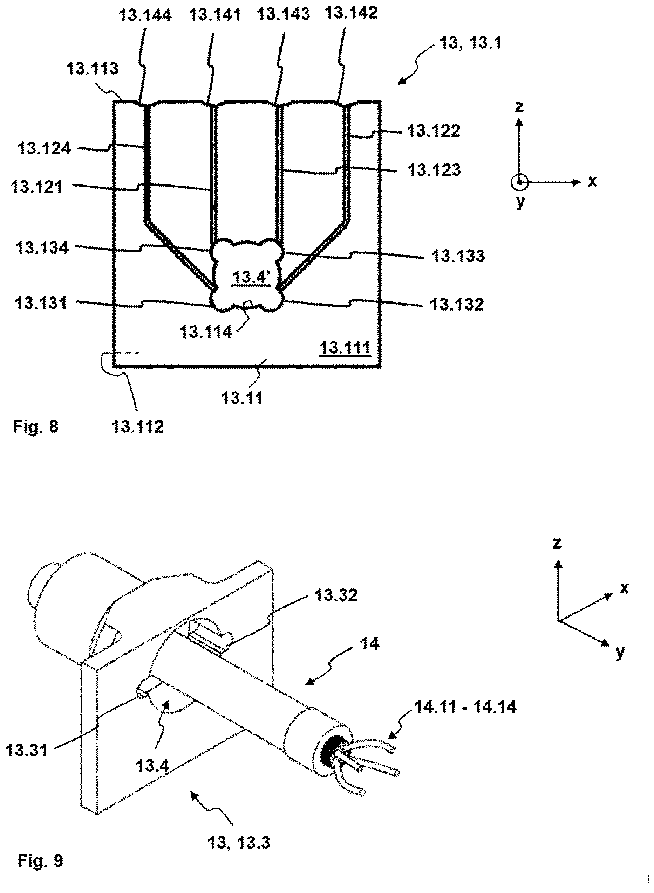

In der Ausführungsform nach Fig. 8 weist das Trägerelement 13.1 vorzugsweise zwei grösste axiale Ausdehnungen entlang der Querachse x und der Vertikalachse z auf. Entlang der Längsachse y weist das Trägerelement 13.1 eine kleinste axiale Ausdehnung auf.

Das Trägerelement 13.1 ist vorzugsweise quaderförmig mit sechs Seitenflächen. Die Seitenflächen sind unterschiedlich gross. Zwei der sechs Seitenflächen liegen parallel zur grössten axialen Ausdehnung und zur zweitgrössten axialen Ausdehnung des Trägerelementes 13.1. Sie weisen im Vergleich mit den anderen vier Seitenflächen eine grösste Oberfläche auf. Sie werden erste Stirnfläche 13.111 und weitere Stirnfläche 13.112 genannt. Die anderen vier Seitenflächen grenzen sowohl an die erste Stirnfläche 13.111 als auch an die weitere Stirnfläche 13.112. Sie bilden einen Übergang von der ersten Stirnfläche 13.111 zur weiteren Stirnfläche 13.112. Eine der vier Seitenflächen wird Mantelfläche 13.113 genannt.

Das Trägerelement 13.1 weist einen Körper 13.11 aus elektrisch isolierendem Material wie Al₂O₃, Keramik, Al₂O₃-Keramik, faserverstärkter Kunststoff, usw. Vorzugsweise ist der faserverstärkte Kunststoff ein schwer entflammbarer und flammenhemmender Verbundwerkstoff aus Epoxidharz und Glasfasergewebe wie Flame Retardant (FR-4).

In der dritten Ausführungsform nach Fig. 8 weist das Trägerelement 13.1 eine Durchgangsöffnung 13.4' auf. Die Durchgangsöffnung 13.4' reicht entlang der Längsachse y von der ersten Stirnfläche 13.111 zur weiteren Stirnfläche 13.112. Vorzugsweise weist die Durchgangsöffnung 13.4' einen Querschnitt auf, welcher demjenigen des Signalkabels 14 entspricht. Die Durchgangsöffnung 13.4' weist eine Innenfläche 13.114 auf. Die Innenfläche 13.114 bildet einen Übergang von der ersten Stirnfläche 13.111 zur weiteren Stirnfläche 13.112.

Das Trägerelement 13.1 weist Leiterbahnen 13.121 - 13.124 auf. Die Leiterbahnen 13.121 - 13.124 sind direkt auf dem Körper 13.11 angeordnet. Vorzugsweise werden die Leiterbahnen 13.121 - 13.124 in einer direkt auf dem Körper 13.11 aufgebrachten elektrisch leitfähigen Dünnschicht strukturiert. Die elektrisch leitfähige Dünnschicht besteht aus einer thermokaschierten Metallfolie oder durch Abscheidung von Metall. Als Metall lassen sich Kupfer, Kupferlegierungen, Gold, Goldlegierungen, Platin, Platinlegierungen, usw. verwenden. Die Abscheidung von Metall erfolgt durch chemische Gasphasenabscheidung, physikalische Gasphasenabscheidung, usw. Der Begriff "Dünnschicht" im Sinne der Erfindung bedeutet, dass sie senkrecht zu ihrer flächigen Ausdehnung eine Dicke von vorzugsweise kleiner/gleich 0.1mm aufweist. Vorzugsweise erfolgt die Strukturierung der Leiterbahnen 13.121 - 13.124 durch Schablonen, Photolithographie und Laserablation.

Vorzugsweise verlaufen die Leiterbahnen 13.121 - 13.124 in einem Bereich des Trägerelementes 13.1 parallel zueinander. In diesem Bereich des Trägerelementes 13.1 ist ein gegenseitiger Abstand der Leiterbahnen 13.121 - 13.124 vorzugsweise kleiner/gleich 0.3mm.

Vorzugsweise weist jede Leiterbahn 13.121 - 13.124 ein erstes Ende und ein zweites Ende auf. Am ersten Ende befindet sich eine Signalleiter-Kontaktfläche 13.131 - 13.134. Am zweiten Ende befindet sich eine Verbindungsleiter-Kontaktfläche 13.141 - 13.144.

Das Trägerelement 13.1 weist mindestens eine erste Leiterbahn 13.121 - 13.123 und mindestens eine weitere Leiterbahn 13.124 auf.

In den beiden Ausführungsformen des Trägerelementes 13.1 nach Fig. 4, 5 und 8 weist das Trägerelement 13.1 drei erste Leiterbahnen 13.121 - 13.123 mit je einer ersten Signalleiter-Kontaktfläche 13.131 - 13.133 und je einer ersten Verbindungsleiter-Kontaktfläche 13.141 - 13.143 sowie eine weitere Leiterbahn 13.124 mit einer weiteren Signalleiter-Kontaktfläche 13.134 und einer weiteren Verbindungsleiter-Kontaktfläche 13.144 auf.

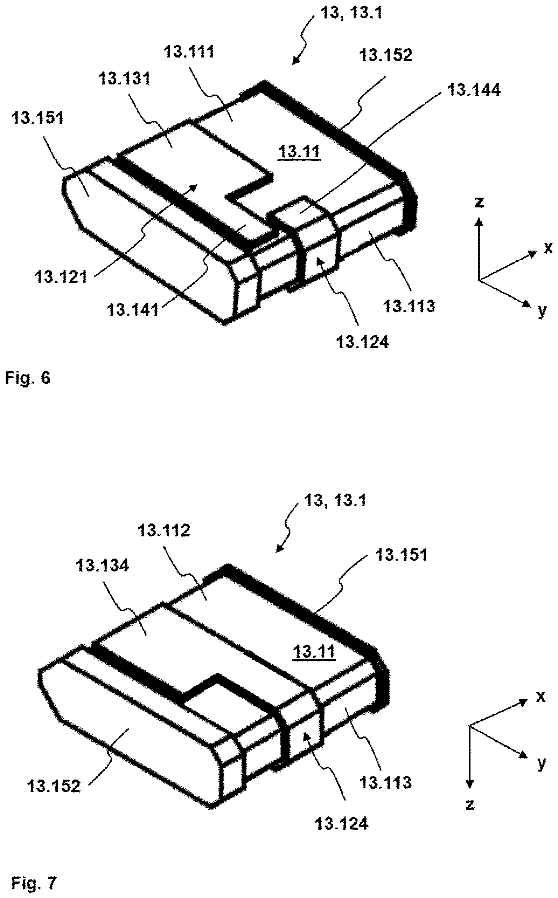

In der Ausführungsform des Trägerelementes 13.1 nach Fig. 6 und 7 weist das Trägerelement 13.1 eine erste Leiterbahn 13.121 mit einer ersten Signalleiter-Kontaktfläche 13.131 und einer ersten Verbindungsleiter-Kontaktfläche 13.141 sowie eine weitere Leiterbahn 13.124 mit einer weiteren Signalleiter-Kontaktfläche 13.134 und einer weiteren Verbindungsleiter-Kontaktfläche 13.144 auf.

In der ersten Ausführungsform des Trägerelementes 13.1 nach Fig. 4 und 5 sind zwei erste Leiterbahnen 13.121, 13.122 vollständig auf der ersten Stirnfläche 13.111 angeordnet und eine erste Leiterbahn 13.123 sowie die weitere Leiterbahn 13.124 sind auf der ersten Stirnfläche 13.111, auf der Mantelfläche 13.113 und auf der weiteren Stirnfläche 13.112 angeordnet. Zwei erste Signalleiter-Kontaktflächen 13.131, 13.132 und alle vier Verbindungsleiter-Kontaktflächen 13.141 - 13.144 sind auf der ersten Stirnfläche 13.111 angeordnet und eine erste Signalleiter-Kontaktfläche 13.133 und die weitere Signalleiter-Kontaktfläche 13.134 sind auf der zweiten Stirnfläche 13.112 angeordnet.

In der zweiten Ausführungsform des Trägerelementes 13.1 nach Fig. 6 und 7 ist die erste Leiterbahn 13.121 vollständig auf der ersten Stirnfläche 13.111 angeordnet und die weitere Leiterbahn 13.124 ist auf der ersten Stirnfläche 13.111, auf der Mantelfläche 13.113 und auf der weiteren Stirnfläche 13.112 angeordnet. Die erste Signalleiter-Kontaktfläche 13.131 und alle beiden Verbindungsleiter-Kontaktflächen 13.141, 13.144 sind auf der ersten Stirnfläche 13.111 angeordnet und die weitere Signalleiter-Kontaktfläche 13.134 ist auf der zweiten Stirnfläche 13.112 angeordnet.

In der dritten Ausführungsform des Trägerelementes 13.1 nach Fig. 8 sind alle vier Leiterbahnen 13.121 - 13.124 auf der ersten Stirnfläche 13.111 angeordnet. Alle vier Verbindungsleiter-Kontaktflächen 13.141 - 13.144 sind auf der Mantelfläche 13.113 angeordnet. Vorzugsweise sind die Verbindungsleiter-Kontaktflächen 13.141 - 13.144 Kerben in der Mantelfläche 13.113. Und alle vier Signalleiter-Kontaktflächen 13.131 - 13.134 sind auf der Innenfläche 13.114 angeordnet. Vorzugsweise sind die Signalleiter-Kontaktflächen 13.131 - 13.134 Kerben in der Innenfläche 13.114.

In den beiden Ausführungsformen nach Fig. 4 bis 7 weist das Trägerelement 13.1 mindestens ein Führungselement 13.151, 13.152 auf. Vorzugsweise weist das Trägerelement 13.1 entlang seiner grössten axialen Ausdehnung entlang der Querachse x zwei Enden auf. Am ersten Ende befindet sich ein erstes Führungselement 13.151, am zweiten Ende befindet sich ein zweites Führungselement 13.152. Die Führungselemente 13.151, 13.152 erstrecken sich entlang der Längsachse y. Vorzugsweise ist jedes der Führungselemente 13.151, 13.152 eine Wulst auf dem Körper 13.11. Ein Aussenradius der Wulst ist konstant bezüglich einer endständigen, sich entlang der Längsachse y erstreckenden Kante des Körpers 13.11. Vorzugsweise werden die Führungselemente 13.151, 13.152 in einer direkt auf dem Körper 13.11 aufgebrachten elektrisch leitfähigen Dünnschicht strukturiert. Die Führungselemente 13.151, 13.152 haben eine Dicke von vorzugsweise kleiner/gleich 0.1mm.

In einer ersten Ausführungsform der Signaldurchführungswand 13.3 nach Fig. 9 bis 17 wird das Trägerelement 13.1 in der Signaldurchführungsöffnung 13.4 gehalten. Dazu weist die Signaldurchführungswand 13.3 mindestens ein Halteelement 13.31, 13.32 auf. Vorzugsweise weist die Signaldurchführungswand 13.3 zwei nutförmige Halteelemente 13.31, 13.32 in der Umrandung der Signalleiteröffnung 13.4 auf. Die wulstförmigen Führungselemente 13.151, 13.152 und die nutförmigen Haltemittel 13.31, 13.32 sind passend zueinander gearbeitet. Das Trägerelement 13.1 ist über die Führungselemente 13.151, 13.152 in die Halteelemente 13.31, 13.32 einsetzbar. Entlang der Längsachse y entspricht ein Innenradius der nutförmigen Halteelemente 13.31, 13.32 von der Grösse her dem Aussenradius der wulstförmigen Führungselemente 13.151, 13.152. Durch Einsetzen des Führungselementes 13.151, 13.152 in das Halteelement 13.31, 13.32 wird das Trägerelement 13.1 in der Signaldurchführungswand 13.3 gehalten. Vorzugsweise erfolgt das Halten durch Formschluss. Das Halten verhindert ein Herausfallen des eingesetzten Trägerelementes 13.1 aus der Signaldurchführungswand 13.3. Das eingesetzte Trägerelement 13.1 wird vom Halteelement 13.31, 13.32 in einer definierten Halteposition gehalten. Die Führungselemente 13.151, 13.152 und die Haltemittel 13.31, 13.32 sind metallisch und bilden beim Halten einen elektrischen Kontakt.

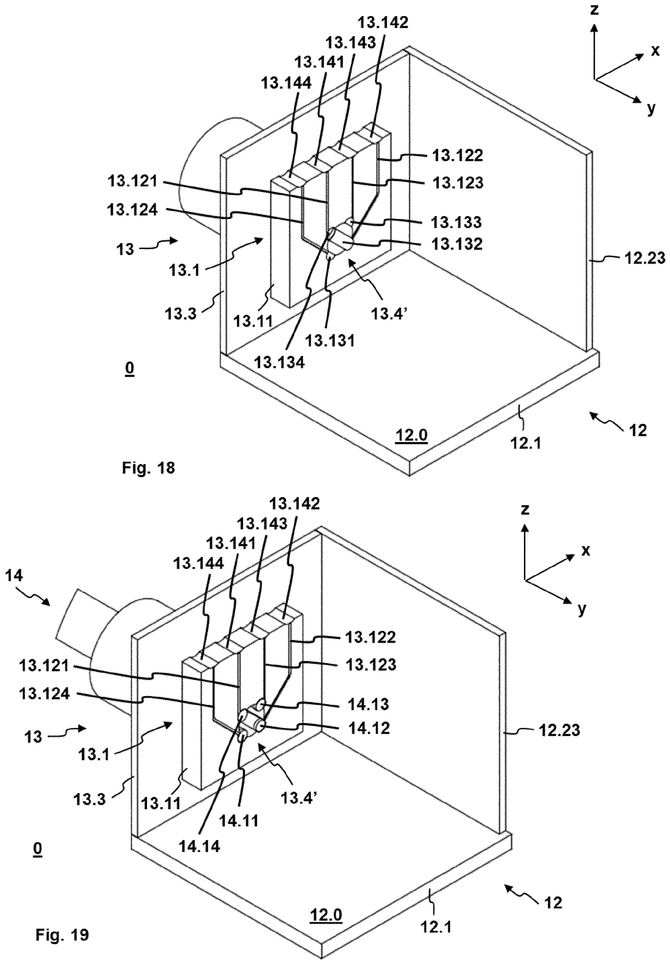

In einer zweiten Ausführungsform der Signaldurchführungswand 13.3 nach Fig. 18 bis 22 ist das Trägerelement 13.1 an der Signaldurchführungswand 13.3 befestigt. Vorzugsweise erfolgt das Befestigen im Stoffschluss mittels Klebstoff aus Epoxid, Polyurethan, Cyanacrylat, Methylmethacrylat, usw. Das Trägerelement 13.1 ist über seine weitere Stirnfläche 13.112 an der zweiten Seite der Signaldurchführungswand 13.3 befestigt. Das Trägerelement 13.1 ist derart an der Signaldurchführungswand 13.3 angeordnet, dass die Signalleiteröffnung 13.4 und Durchgangsöffnung 13.4' deckungsgleich sind.

Vorzugsweise ist die Signaldurchführungswand 13.3 im mechanisch stabil mit dem Gehäuse 12 verbundenen Zustand geerdet, Signaldurchführungswand 13.3 und Gehäuse 12 befinden sich auf elektrischen Potenzial des lokalen Erdreiches. Signaldurchführungswand 13.3 und Gehäuse 12 bilden so einen Faraday'schen Käfig gegenüber elektromagnetische Strahlung aus der Umgebung 0.

Die Signaldurchführung 13 weist mindestens zwei Verbindungsleiter 13.21 - 13.24 auf. Die Verbindungsleiter 13.21 - 13.24 haben einen Durchmesser von kleiner/gleich 0.5mm. Die Verbindungsleiter 13.21 - 13.24 leiten die Signale S1 - S4 von der Aufnehmereinheit 11 zur Signaldurchführung 13 ab. Mindestens ein erster Verbindungsleiter 13.21 - 13.23 leitet erste Signale S1 - S3 ab, mindestens ein zweiter Verbindungsleiter 13.24 leitet ein weiteres Signal S4 ab. Jeder Verbindungsleiter 13.21 - 13.24 weist ein erstes Ende und ein zweites Ende auf. Die Verbindungsleiter 13.21 - 13.24 bewerkstelligen Kontaktierungen mit der Aufnehmereinheit 11 und der Signaldurchführung 13. Vorzugsweise erfolgen die Kontaktierungen durch einen Stoffschluss wie Drahtbonden, Löten, usw. Beim Drahtbonden eignen sich Verfahren wie Thermokompressionsbonden, Thermosonic-Ball-Wedge-Bonden, Ultraschall-Wedge-Wedge-Bonden usw.

In den beiden Ausführungsformen des piezoelektrischen Aufnehmers 1 nach Fig. 1 und 3 kontaktiert je ein erster Verbindungsleiter 13.21 - 13.23 mit seinem ersten Ende genau eine erste Aufnehmereinheit-Kontaktfläche 11.81 - 11.83 und mit seinem zweiten Ende kontaktiert je ein erster Verbindungsleiter 13.21 - 13.23 genau eine erste Verbindungsleiter-Kontaktfläche 13.141 - 13.143. Der weitere Verbindungsleiter 13.24 kontaktiert mit seinem ersten Ende die weitere Aufnehmereinheit-Kontaktfläche 11.84 und mit seinem zweiten Ende kontaktiert der weitere Verbindungsleiter 13.24 die weitere Verbindungsleiter-Kontaktfläche 13.144.

In der Ausführungsform der Aufnehmereinheit 11 nach Fig. 2, die nicht in den Schutzbereich der Ansprüche fällt, kontaktiert der erste Verbindungsleiter 13.21 mit seinem ersten Ende die erste Aufnehmereinheit-Kontaktfläche 11.81 und mit seinem zweiten Ende kontaktiert der erste Verbindungsleiter 13.21 die erste Verbindungsleiter-Kontaktfläche 13.141. Und der weitere Verbindungsleiter 13.24 kontaktiert mit seinem ersten Ende die weitere Aufnehmereinheit-Kontaktfläche 11.84 und mit seinem zweiten Ende kontaktiert der weitere Verbindungsleiter 13.24 die weitere Verbindungsleiter-Kontaktfläche 13.144.

### DAS SIGNALKABEL

Das Signalkabel 14 ist bereichsweise an der Signaldurchführung 13 befestigt. Das Signalkabel 14 ist in der Umgebung 0 ausserhalb des Gehäuses 12 angeordnet. Das Signalkabel 14 weist mindestens zwei Signalleiter 14.11 - 14.14, eine Kabelisolation 14.2 und einen Schutzmantel 14.3 auf.

In der ersten Ausführungsform der Signaldurchführungswand 13.3 nach Fig. 9 bis 17 ragen Enden der Signalleiter 14.11 - 14.14 durch die Signalleiteröffnung 13.4 in das Gehäuseinnere 12.0.

In einer zweiten Ausführungsform der Signaldurchführungswand 13.3 kombiniert mit der dritten Ausführungsform des Trägerelementes 13.1 nach Fig. 18 bis 22 ragen Enden der Signalleiter 14.11 - 14.14 durch die Signalleiteröffnung 13.4 in die Durchgangsöffnung 13.4' im Gehäuseinneren 12.0.

Die Signalleiter 14.11 - 14.14 sind aus elektrisch leitfähigem Material wie Kupfer, Kupferlegierungen, Gold, Goldlegierungen, Aluminium, Aluminiumlegierungen, usw. Vorzugsweise weist jeder Signalleiter 14.11 - 14.14 eine elektrische Isolationshülle auf. Die Signalleiter 14.11 - 14.14 haben einen Durchmesser von kleiner/gleich 0.5mm.

Das Signalkabel 14 weist mindestens einen ersten Signalleiter 14.11 - 14.13 und mindestens einen weiteren Signalleiter 14.14 auf. In den beiden Ausführungsformen des piezoelektrischen Aufnehmers 1 nach Fig. 1 und 3 weist das Signalkabel 14 drei erste Signalleiter 14.11 - 14.13 und einen weiteren Signalleiter 14.14 auf. In der Ausführungsform des piezoelektrischen Aufnehmers 1 nach Fig. 2, die nicht in den Schutzbereich der Ansprüche fällt, weist das Signalkabel 14 einen ersten Signalleiter 14.11 und einen weiteren Signalleiter 14.14 auf.

Die Kabelisolation 14.2 umschliesst die Signalleiter 14.11 - 14.14 in radialer Richtung vollständig. Die Kabelisolation 14.2 isoliert die Signalleiter 14.11 - 14.14 elektrisch gegenüber dem Schutzmantel 14.3. Die Kabelisolation 14.2 ist aus elektrisch isolierendem Material wie Al₂O₃, Keramik, Al₂O₃-Keramik, faserverstärkter Kunststoff, usw.

Der Schutzmantel 14.3 umschliesst die Kabelisolation 14.2 in radialer Richtung gegenüber der Umgebung 0 wasser- und gasdicht. Der Schutzmantel 14.3 schützt die Kabelisolation 14.2 sowie die Signalleiter 14.11 - 14.14 vor schädlichen Umgebungseinflüssen wie Verunreinigungen (Staub, Feuchtigkeit, usw.) sowie vor elektromagnetischen Wellen. Der Schutzmantel 14.3 ist aus mechanisch beständigem Material wie aus Metall, Kunststoff, usw.

Je einer der Signalleiter 14.11 - 14.14 des Signalkabels 14 kontaktiert genau eine der Leiterbahnen 13.121 - 13.124 des Trägerelementes 13.1. Vorzugsweise erfolgt das Kontaktieren durch einen Stoffschluss wie Löten, leitendes Kleben, Drahtbonden, usw. Ein Ende des mindestens einen ersten Signalleiters 14.11 - 14.13 kontaktiert die mindestens eine erste Signalleiter-Kontaktfläche 13.131 - 13.133 und ein Ende des mindestens einen weiteren Signalleiters 14.14 kontaktiert die mindestens eine weitere Signalleiter-Kontaktfläche 13.134.

In der dritten Ausführungsform des Trägerelementes 13.1 nach Fig. 8 und 18 bis 22 sind die Signalleiter-Kontaktflächen 13.131 - 13.134 Kerben in der Innenfläche 13.114 der Durchgangsöffnung 13.4'. Die Kerben weisen einen Durchmesser auf, der weitgehend dem Durchmesser der Signalleiter 14.11 - 14.14 entspricht. Somit werden die an den Signalleiter-Kontaktflächen 13.131 - 13.134 angeordneten Signalleiter 14.11 - 14.14 von den Kerben im Formschluss gehalten.

Die Signale S1 - S4 werden über die Leiterbahnen 13.121 - 13.124 des Trägerelementes 3.1 zu den Signalleitern 14.11 - 14.14 des Signalkabels 14 abgeleitet. Vorzugsweise erfolgt die Ableitung der Signale S1 - S4 masseisoliert. Im Sinne der Erfindung bedeutet der Begriff "masseisoliert" elektrisch isoliert gegenüber der Erdung des piezoelektrischen Aufnehmers 1.

Die Signaldurchführung 13 weist eine Vergussmasse 13.5 auf. Die Vergussmasse 13.5 ist ein chemisch härtender Klebstoff oder ein physikalisch abbindbarer Klebstoff oder eine Kombination aus einem chemisch härtenden Klebstoff und einem physikalisch abbindbaren Klebstoff. Vorzugsweise besteht die Vergussmasse 13.5 aus Klebstoff wie Epoxid, Polyurethan, Cyanacrylat, Methylmethacrylat, usw. Die Vergussmasse 13.5 ist ein elektrischer Isolator mit einem spezifischen elektrischen Widerstand von grösser 10¹²Ωmm²/m.

In der ersten Ausführungsform der Signaldurchführungswand 13.3 nach Fig. 9 bis 17 ist vorzugsweise so viel Vergussmasse 13.5 auf die Signalleiter 14.11 - 14.14 in der Signalleiteröffnung 13.4 aufgebracht, dass die Signalleiteröffnung 13.4 vollständig verschlossen ist. Die Vergussmasse 13.5 ist in der Signalleiteröffnung 13.4 bereichsweise auch auf das Trägerelement 13.1 und auf die Signaldurchführungswand 13.3 aufgebracht. Die auf dem Trägerelement 13.1 und auf der Signaldurchführungswand 13.3 ausgehärtete und/oder abgebundene Vergussmasse 13.5 sichert das haltend in der Signaldurchführungswand 13.3 eingesetzte Trägerelement 13.1 mechanisch ab. Und die ausgehärtete und/oder abgebundene Vergussmasse 13.5 verschliesst die Signalleiteröffnung 13.4 wasser- und gasdicht.

In einer zweiten Ausführungsform der Signaldurchführungswand 13.3 kombiniert mit der dritten Ausführungsform des Trägerelementes 13.1 nach Fig. 18 bis 22 ist vorzugsweise so viel Vergussmasse 13.5 auf die Signalleiter 14.11 - 14.14 in der Durchgangsöffnung 13.4' aufgebracht, dass die Durchgangsöffnung 13.4' vollständig verschlossen ist. Die ausgehärtete und/oder abgebundene Vergussmasse 13.5 verschliesst die Durchgangsöffnung 13.4' wasser- und gasdicht.

Der wasser- und gasdichte Verschluss verhindert ein Eindringen von Feuchtigkeit über die Signalleiter 14.11 - 14.14 in das Gehäuseinnere 12.0 zum Piezoelement 11.11 - 11.13, wo Feuchtigkeit eine Funktionsfähigkeit des Piezoelementes 11.11 - 11.13 beeinträchtigen kann, denn piezoelektrisches Material wie Quarz ist stark hygroskopisch.

Die ausgehärtete und/oder abgebundene Vergussmasse 13.5 befestigt die Signalleiter 14.11 - 14.14 zugentlastet. Aufgrund der Zugentlastung der Signalleiter 14.11 - 14.14 können mechanische Belastungen von den Signalleitern 14.11 - 14.14 nicht in das Gehäuseinnere 12.0 übertragen werden und dort zu Beschädigungen wie ein Abreissen oder Anreissen von Verbindungsleitern 13.21 - 13.24 führen. Solche mechanische Belastungen stammen von Verdrehungen, Verzwirbelungen, usw. der Signalleiter 14.11 - 14.14 um deren längliche Ausdehnungsachse.

### DAS MONTAGEVERFAHREN

Eine Montage des piezoelektrischen Aufnehmers 1 erfolgt in mehreren Schritten.

Für die erste Ausführungsform des piezoelektrischen Aufnehmers 1 nach Fig. 1 ist die Montage in den Ansichten nach Fig. 9 bis 17 dargestellt und wird nachfolgend beschrieben:

In einem ersten Schritt der Montage nach Fig. 9 werden die Signaldurchführung 13 mit der Signaldurchführungswand 13.3 und das Signalkabel 14 mit den Signalleitern 14.11 - 14.14 bereitgestellt. Die Signaldurchführungswand 13.3 weist eine Signalleiteröffnung 13.4 auf.

Enden der Signalleiter 14.11 - 14.14 werden abisoliert. Die abisolierten Enden der Signalleiter 14.11 - 14.14 werden von der Umgebung 0 her durch die Signalleiteröffnung 13.4 geschoben. Die abisolierten Enden der Signalleiter 14.11 - 14.14 ragen durch die Signalleiteröffnung 13.4.

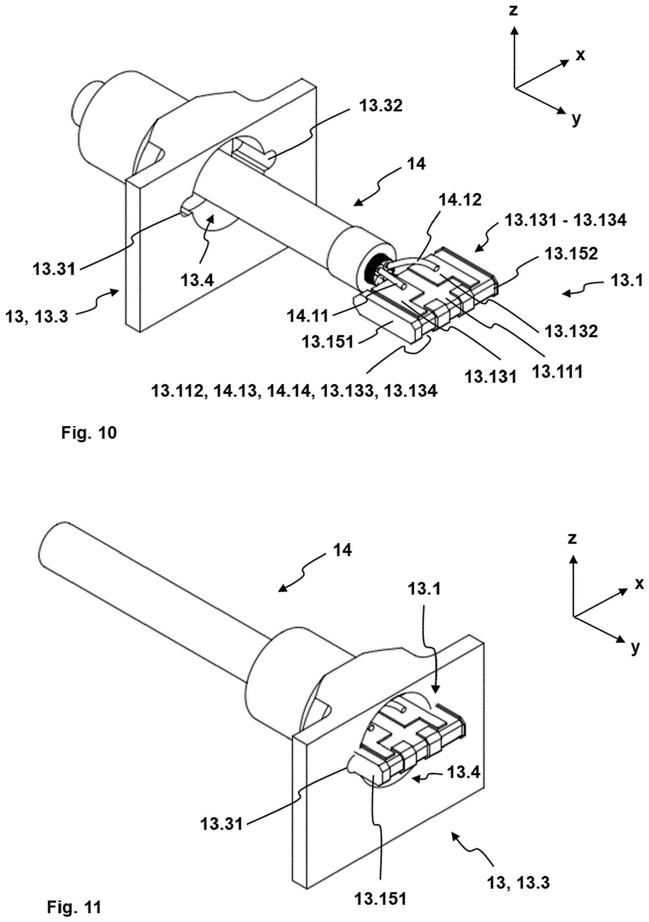

In einem zweiten Schritt der Montage nach Fig. 10 wird das Trägerelement 13.1 mit mindestens zwei Leiterbahnen 13.121 - 13.124 auf Stirnflächen 13.111, 13.112 bereitgestellt. Die Leiterbahnen 13.121 - 13.124 enden in Signalleiter-Kontaktflächen 13.131 - 13.134.

Das Trägerelement 13.1 wird so an der Signalleiteröffnung 13.4 ausgerichtet, dass die Enden der Signalleiter 14.11 - 14.14 an den Stirnflächen 13.111, 13.112 zu liegen kommen. Das Ende des mindestens einen ersten Signalleiters 14.11 - 14.13 liegt an der ersten Stirnfläche 13.111 an, Das Ende des mindestens einen weiteren Signalleiters 14.14 liegt an der weiteren Stirnfläche 13.112 an. Im Sinne der Erfindung wird mit dem Ausdruck "anliegen" eine räumliche Positionierung der Enden der Signalleiter 14.11 - 14.14 in einer Distanz entlang der Vertikalachse z von kleiner/gleich 1mm, vorzugsweise kleiner/gleich 0.5mm von den Signalleiter-Kontaktflächen 13.131 - 13.134 bezeichnet. In der in der Ansicht von Fig. 10 dargestellten ersten Ausführungsform des piezoelektrischen Aufnehmers 1 nach Fig. 1 sind nur die Enden von zwei ersten Signalleitern 14.11, 14.12, die an zwei ersten Signalleiter-Kontaktflächen 13.131, 13.132 der ersten Stirnfläche 13.111 anliegen, sichtbar. Die Enden des dritten ersten Signalleiters 14.13 und des weiteren Signalleiters 14.14, die an der dritten ersten Signalleiter-Kontaktfläche 13.133 und an weiteren Signalleiter-Kontaktfläche 13.134 der weiteren Stirnfläche 13.112 anliegen, sind verdeckt und somit nicht sichtbar.

Die Enden der Signalleiter 14.11 - 14.14 werden nun mit den mit den Signalleiter-Kontaktflächen 13.131 - 13.134 kontaktiert. Das Kontaktieren erfolgt mit einem Werkzeug wie ein Lötkolben, ein Lötbrenner, usw. In der in der Ansicht von Fig. 10 dargestellten ersten Ausführungsform des piezoelektrischen Aufnehmers 1 nach Fig. 1 wird je ein Ende eines der drei ersten Signalleiter 14.11 - 14.13 mit genau einer der drei ersten Signalleiter-Kontaktflächen 13.131 - 13.133 kontaktiert. Das Ende des weiteren Signalleiters 14.14 wird mit der weiteren Signalleiter-Kontaktfläche 13.134 kontaktiert.

In einem dritten Schritt der Montage nach Fig. 11 wird das Trägerelement 13.1 in der Signaldurchführungswand 13.3 eingesetzt. Das Trägerelement 13.1 weist wulstförmige Führungselemente 13.151, 13.152 auf, welche in nutenförmige Halteelemente 13.31, 13.32 der Signaldurchführungswand 13.3 eingesetzt werden. Das Einsetzen des Führungselemente 13.151, 13.152 in die Halteelemente 13.31, 13.32 erfolgt durch Verschieben des Trägerelementes 13.1 entlang der Längsachse y in die Signalleiteröffnung 13.4. Das eingesetzte Trägerelement 13.1 wird über die Halteelemente 13.31, 13.32 in der Signaldurchführungswand 13.3 gehalten.

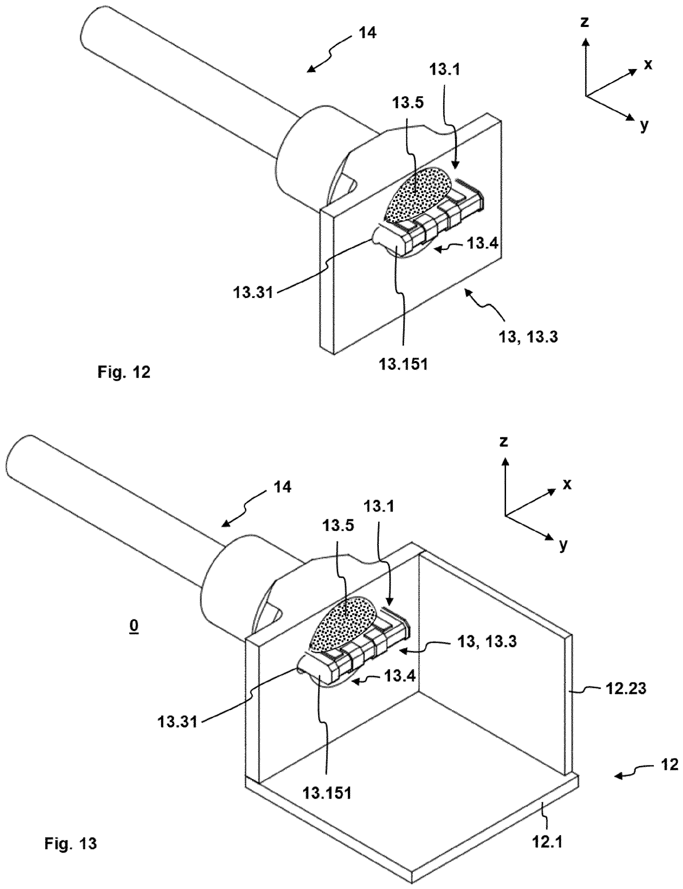

In einem vierten Schritt der Montage nach Fig. 12 werden die mit den Signalleiter-Kontaktflächen 13.131 - 13.134 kontaktierten Signalleiter 14.11 - 14.14 mit Vergussmasse 13.5 vergossen. Die Vergussmasse 13.5 wird durch die Signalleiteröffnung 13.4 auf die Signalleiter 14.11 - 14.14 und bereichsweise auch auf das Trägerelement 13.1 und die Umrandung der Signalleiteröffnung 13.4 aufgebracht. Die Signalleiteröffnung 13.4 wird so vollständig mit Vergussmasse 13.5 verschlossen. Die Vergussmasse 13.5 wird ausgehärtet und/oder abgebunden und die Signalleiteröffnung 13.4 wird wasser- und gasdicht verschlossen.

Die ausgehärtete und/oder abgebundene Vergussmasse 13.5 sichert auch das haltend in der Signaldurchführungswand 13.3 eingesetzte Trägerelement 13.1 mechanisch ab.

In einem fünften Schritt der Montage nach Fig. 13 werden Teile des Gehäuses 12 bereitgestellt. Als Teile des Gehäuses 12 werden ein Gehäuseboden 12.1, drei Gehäusewände 12.21 - 12.23 und ein Gehäusedeckel 12.3 bereitgestellt. Der Gehäuseboden 12.1 und jede der drei Gehäusewände 12.21 - 12.23 werden mechanisch stabil mit der Signaldurchführungswand 13.3 verbunden. Das mechanisch stabile Verbinden erfolgt durch ein Werkzeug wie ein Schweisswerkzeug, ein Lötwerkzeug, usw. Somit sind mit dem Gehäuseboden, 12.1, den drei Gehäusewänden 12.21 - 12.23 und der Signaldurchführungswand 13.3 fünf Seitenwände des quaderförmigen Gehäuses 12 mechanisch stabil miteinander verbunden. Durch das mechanische stabile Verbinden wird das Gehäuseinnere 12.0 gebildet. In der in den Ansichten von Fig. 13 bis 15 dargestellten ersten Ausführungsform des piezoelektrischen Aufnehmers 1 nach Fig. 1 sind der Gehäuseboden 12.1, eine zweite Gehäusewand 12.22 und die Signaldurchführungswand 13.3 dargestellt. Die erste und dritte Gehäusewand 12.21, 12.23 sind in den Ansichten von Fig. 13 bis 15 nicht dargestellt. Das Nichtdarstellen der ersten und dritten Gehäusewand 12.21, 12.23 erfolgt einzig aus dem Grund, um Einblick in das Gehäuseinnere 12.0 zu bieten. In der Ansicht von Fig. 17 sind die erste und dritte Gehäusewand 12.21, 12.23 dann auch dargestellt. Auch ist in den Ansichten von Fig. 13 bis 15 der Gehäusedeckel 12.3 noch nicht mechanisch stabil mit dem Gehäuse 12 verbunden. Aufgrund des noch fehlenden Gehäusedeckels 12.3 weist das Gehäuse 12 eine Gehäuseöffnung auf. Durch die Gehäuseöffnung ist das Gehäuseinnere 12.0 von der Umgebung 0 her zugänglich.

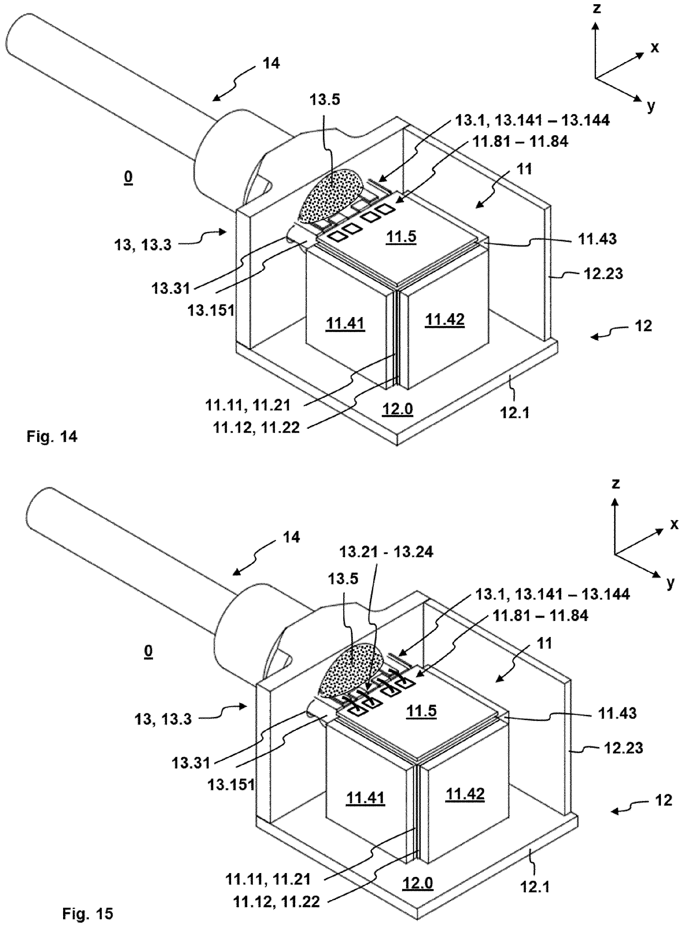

In einem sechsten Schritt der Montage nach Fig. 14 wird die Aufnehmereinheit 11 bereitgestellt. Die Aufnehmereinheit 11 wird in das Gehäuseinnere 12.0 gesetzt und am Gehäuse 12 befestigt. Vorzugsweise wird die Aufnehmereinheit 11 über den Grundkörper 11.3 am Gehäuseboden 12.1 befestigt.

In einem siebten Schritt der Montage nach Fig. 15 und 14 werden die Verbindungsleiter 13.21 - 13.24 bereitgestellt. Die Verbindungsleiter 13.21 - 13.24 werden mit Aufnehmereinheit-Kontaktflächen 11.81 - 11.84 des Aufnehmerelementes 11 und mit Verbindungsleiter-Kontaktflächen 13.141 - 13.144 der Leiterbahnen 13.121 - 13.124 des Trägerelementes 13.1 kontaktiert. Das Kontaktieren erfolgt mit einem Kontaktierwerkzeug wie ein Drahtbonder, usw. Das Kontaktierwerkzeug wird durch die Gehäuseöffnung in das Gehäuseinnere 12.0 geführt.

Fig 16 ist ein vergrösserter Ausschnitt von Fig. 15. In der in den Ansichten von Fig. 15 und 16 dargestellten ersten Ausführungsform des piezoelektrischen Aufnehmers 1 nach Fig. 1 wird je ein erstes Ende eines der drei ersten Verbindungsleiter 13.21 - 13.23 mit genau einer der drei ersten Aufnehmereinheit-Kontaktflächen 11.81 - 11.83 kontaktiert und je ein zweites Ende eines der drei ersten Verbindungsleiter 13.21 - 13.23 wird mit genau einer der drei ersten Verbindungsleiter-Kontaktflächen 13.141 - 13.143 kontaktiert. Das erste Ende des weiteren Verbindungsleiters 13.24 wird mit der weiteren Aufnehmereinheit-Kontaktfläche 11.84 kontaktiert und das zweite Ende des weiteren Verbindungsleiters 13.24 wird mit der weiteren Verbindungsleiter-Kontaktfläche 13.144 kontaktiert.

In einem achten Schritt der Montage nach Fig. 17 wird die Gehäuseöffnung des Gehäuses 12 mit dem Gehäusedeckel 12.3 wasser- und gasdicht verschlossen. Der Verschluss erfolgt durch Stoffschluss wie Schweissen, Löten, Kleben, usw. Der Gehäusedeckel 12.3 bildet die sechste und letzte Seitenfläche des quaderförmigen Gehäuses 12.

Für die dritte Ausführungsform des piezoelektrischen Aufnehmers 1 nach Fig. 3 ist die Montage in den Ansichten nach Fig. 18 bis 22 dargestellt und wird nachfolgend beschrieben:

In einem ersten Schritt der Montage nach Fig. 18 werden Teile des Gehäuses 12, die Signaldurchführung 13 mit der Signaldurchführungswand 13.3 und das Trägerelement 13.1 bereitgestellt. Als Teile des Gehäuses 12 werden ein Gehäuseboden 12.1, drei Gehäusewände 12.21 - 12.23 und ein Gehäusedeckel 12.3 bereitgestellt.

In einem zweiten Schritt der Montage nach Fig. 18 werden der Gehäuseboden 12.1 und jede der drei Gehäusewände 12.21 - 12.23 mechanisch stabil mit der Signaldurchführungswand 13.3 verbunden. Das mechanisch stabile Verbinden erfolgt durch ein Werkzeug wie ein Schweisswerkzeug, ein Lötwerkzeug, usw. Somit sind mit dem Gehäuseboden, 12.1, den drei Gehäusewänden 12.21 - 12.23 und der Signaldurchführungswand 13.3 fünf Seitenwände des quaderförmigen Gehäuses 12 mechanisch stabil miteinander verbunden. Durch das mechanische stabile Verbinden wird das Gehäuseinnere 12.0 gebildet. In der in den Ansichten von Fig. 18 bis 21 dargestellten dritten Ausführungsform des piezoelektrischen Aufnehmers 1 nach Fig. 3 sind der Gehäuseboden 12.1, eine zweite Gehäusewand 12.22 und die Signaldurchführungswand 13.3 dargestellt. Die erste und dritte Gehäusewand 12.21, 12.23 sind in den Ansichten von Fig. 18 bis 21 nicht dargestellt. Das Nichtdarstellen der ersten und dritten Gehäusewand 12.21, 12.23 erfolgt einzig aus dem Grund, um Einblick in das Gehäuseinnere 12.0 zu bieten. In der Ansicht von Fig. 22 sind die erste und dritte Gehäusewand 12.21, 12.23 dann auch dargestellt. Auch ist in den Ansichten von Fig. 18 bis 21 der Gehäusedeckel 12.3 noch nicht mechanisch stabil mit dem Gehäuse 12 verbunden. Aufgrund des noch fehlenden Gehäusedeckels 12.3 weist das Gehäuse 12 eine Gehäuseöffnung auf. Durch die Gehäuseöffnung ist das Gehäuseinnere 12.0 von der Umgebung 0 her zugänglich.

Im zweiten Schritt der Montage nach Fig. 18 wird das Trägerelement 13.1 an der Signaldurchführungswand 13.3 befestigt. Das Trägerelement 13.1 ist derart an der Signaldurchführungswand 13.3 angeordnet, dass die Signalleiteröffnung 13.4 und Durchgangsöffnung 13.4' deckungsgleich sind.

In einem dritten Schritt der Montage nach Fig. 19 wird das Signalkabel 14 mit den Signalleitern 14.11 - 14.14 bereitgestellt. Enden der Signalleiter 14.11 - 14.14 werden abisoliert. Die abisolierten Enden der Signalleiter 14.11 - 14.14 werden von der Umgebung 0 her durch die Signalleiteröffnung 13.4 geschoben. Die abisolierten Enden der Signalleiter 14.11 - 14.14 ragen durch die Signalleiteröffnung 13.4 in die Durchgangsöffnung 13.4' und liegen in den kerbenförmigen Signalleiter-Kontaktflächen 13.131 - 13.134.

In einem vierten Schritt der Montage nach Fig. 19 werden die Enden der Signalleiter 14.11 - 14.14 mit den mit den Signalleiter-Kontaktflächen 13.131 - 13.134 kontaktiert. Das Kontaktieren erfolgt mit einem Werkzeug wie ein Lötkolben, ein Lötbrenner, usw. In der in der Ansicht von Fig. 19 dargestellten ersten Ausführungsform des piezoelektrischen Aufnehmers 1 nach Fig. 1 wird je ein Ende eines der drei ersten Signalleiter 14.11 - 14.13 mit genau einer der drei ersten Signalleiter-Kontaktflächen 13.131 - 13.133 kontaktiert. Das Ende des weiteren Signalleiters 14.14 wird mit der weiteren Signalleiter-Kontaktfläche 13.134 kontaktiert.

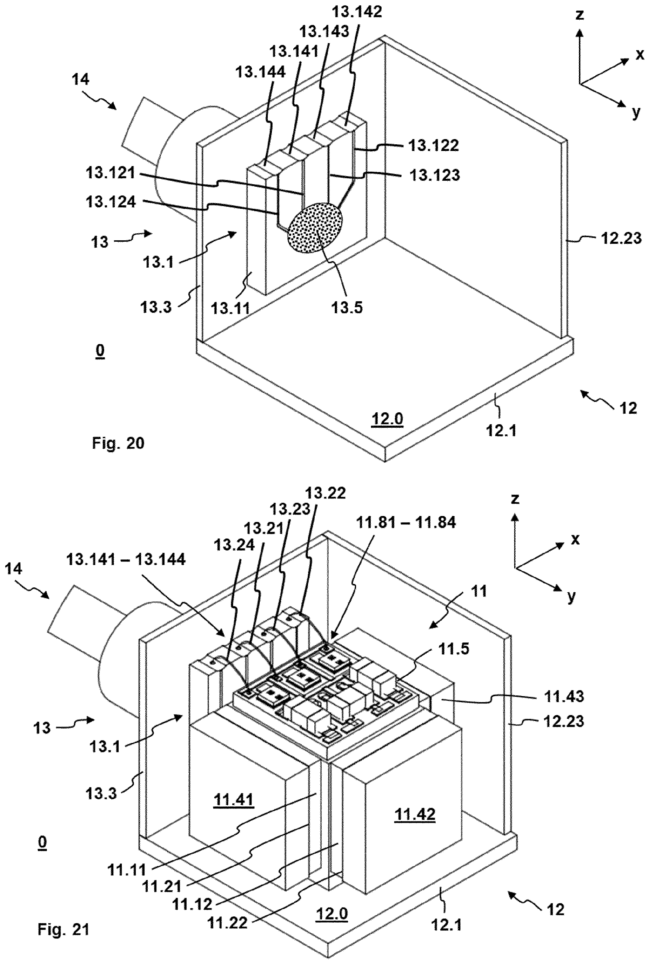

In einem fünften Schritt der Montage nach Fig. 20 werden die mit den Signalleiter-Kontaktflächen 13.131 - 13.134 kontaktierten Signalleiter 14.11 - 14.14 mit Vergussmasse 13.5 vergossen. Die Vergussmasse 13.5 wird durch die Durchgangsöffnung 13.4' auf die Signalleiter 14.11 - 14.14 und bereichsweise auch auf das Trägerelement 13.1 und die Umrandung der Durchgangsöffnung 13.4' aufgebracht. Die Durchgangsöffnung 13.4' wird so vollständig mit Vergussmasse 13.5 verschlossen. Die Vergussmasse 13.5 wird ausgehärtet und/oder abgebunden und die Durchgangsöffnung 13.4' wird wasser- und gasdicht verschlossen.

In einem sechsten Schritt der Montage nach Fig. 21 wird die Aufnehmereinheit 11 bereitgestellt. Die Aufnehmereinheit 11 wird in das Gehäuseinnere 12.0 gesetzt und am Gehäuse 12 befestigt. Vorzugsweise wird die Aufnehmereinheit 11 über den Grundkörper 11.3 am Gehäuseboden 12.1 befestigt.

In einem siebten Schritt der Montage nach Fig. 21 werden die Verbindungsleiter 13.21 - 13.24 bereitgestellt. Die Verbindungsleiter 13.21 - 13.24 werden mit Aufnehmereinheit-Kontaktflächen 11.81 - 11.84 des Aufnehmerelementes 11 und mit Verbindungsleiter-Kontaktflächen 13.141 - 13.144 der Leiterbahnen 13.121 - 13.124 des Trägerelementes 13.1 kontaktiert. Das Kontaktieren erfolgt mit einem Kontaktierwerkzeug wie ein Drahtbonder, usw. Das Kontaktierwerkzeug wird durch die Gehäuseöffnung in das Gehäuseinnere 12.0 geführt.

In einem achten Schritt der Montage nach Fig. 22 wird die Gehäuseöffnung des Gehäuses 12 mit dem Gehäusedeckel 12.3 wasser- und gasdicht verschlossen. Der Verschluss erfolgt durch Stoffschluss wie Schweissen, Löten, Kleben, usw. Der Gehäusedeckel 12.3 bildet die sechste und letzte Seitenfläche des quaderförmigen Gehäuses 12.

### Bezugszeichenliste

- 0: Umgebung
- 1: piezoelektrischer Aufnehmer
- 11: Aufnehmereinheit
- 11.11 - 11.13: Piezoelement
- 11.21 - 11.26: Elektrode
- 11.3: Grundkörper
- 11.41 - 11.43: seismische Masse
- 11.5: Wandlereinheit
- 11.61, 11.62: Isolationselement
- 11.71, 11.72: Kompensationselement
- 11.81 - 11.84: Aufnehmereinheit-Kontaktfläche
- 12: Gehäuse
- 12.0: Gehäuseinnere
- 12.1: Gehäuseboden
- 12.21 - 12.23: Gehäusewand
- 12.3: Gehäusedeckel
- 13: Signaldurchführung
- 13.1: Trägerelement
- 13.11: Körper
- 13.111, 13.112: Stirnfläche
- 13.113: Mantelfläche
- 13.114: Innenfläche
- 13.121 - 13.124: Leiterbahn
- 13.131 - 13.134: Signalleiter-Kontaktfläche
- 13.141 - 13.144: Verbindungsleiter-Kontaktfläche
- 13.151, 13,152: Führungselement
- 13.21 - 13.24: Verbindungsleiter
- 13.3: Signaldurchführungswand
- 13.31, 13.32: Halteelement
- 13.4: Signalleiteröffnung
- 13.4': Durchgangsöffnung
- 13.5: Vergussmasse
- 13.6: Signaldurchführungsflansch
- 14: Signalkabel
- 14.11 - 14.14: Signalleiter
- 14.2: Kabelisolation
- 14.3: Schutzmantel
- S1 - S4: Signal
- x: Querachse
- y: Längsachse
- z: Vertikalachse

## Patentansprüche

1. Piezoelektrischer Beschleunigungsaufnehmer (1) zum Messen einer Beschleunigung; mit einer Aufnehmereinheit (11), welche mindestens ein Piezoelement (11.11 - 11.13) und mindestens zwei Elektroden (11.21 - 11.26) aufweist, welches Piezoelement (11.11 - 11.13) aus piezoelektrischem Material ist und unter der Wirkung der Beschleunigung Polarisationsladungen erzeugt, welche Elektroden (11.21 - 11.26) das Piezoelement (11.11 - 11.13) bereichsweise direkt kontaktieren und die Polarisationsladungen abgreifen; mit einem Gehäuse (12), welches die Aufnehmereinheit (11) wasser- und gasdicht umschliesst; und mit einer Signaldurchführung (13), welche mit den Elektroden (11.21 - 11.26) elektrisch verbunden ist und die Polarisationsladungen als Signale (S1 - S4) durch das Gehäuse (12) zu einer Umgebung (0) ausserhalb des Gehäuses (12) ableitet; wobei der piezoelektrische Beschleunigungsaufnehmer (1) ein Signalkabel (14) aufweist, welches in der Umgebung (0) ausserhalb des Gehäuses (12) angeordnet ist und welches mindestens zwei Signalleiter (14.11 - 14.14) aufweist; **dadurch gekennzeichnet, dass** die Signaldurchführung (13) ein Trägerelement (13.1) aufweist, auf welchem Trägerelement (13.1) mindestens zwei Leiterbahnen (13.121 - 13.124) angeordnet sind; und dass je einer der Signalleiter (14.11 - 14.14) genau eine der Leiterbahnen (13.121 - 13.124) kontaktiert.

2. Piezoelektrischer Beschleunigungsaufnehmer (1) nach Anspruch 1, **dadurch gekennzeichnet, dass** die Signaldurchführung (13) mindestens zwei Verbindungsleiter (13.21 - 13.24) aufweist; dass die Aufnehmereinheit (11) mindestens zwei Aufnehmereinheit-Kontaktflächen (11.81 - 11.84) aufweist, an denen die Signale (S1 - S4) anliegen; dass je einer der Verbindungsleiter (13.21 - 13.24) genau eine der Aufnehmereinheit-Kontaktflächen (11.81 - 11.84) kontaktiert; und dass je einer der Verbindungsleiter (13.21 - 13.24) genau eine der Leiterbahnen (13.121 - 13.124) kontaktiert.

3. Piezoelektrischer Beschleunigungsaufnehmer (1) nach Anspruch 2, **dadurch gekennzeichnet, dass** jede Leiterbahn (13.121 - 13.124) genau eine Signalleiter-Kontaktfläche (13.131 - 13.134) und genau eine Verbindungsleiter-Kontaktfläche (13.141 - 13.144) aufweist; dass je einer der Signalleiter (14.11 - 14.14) genau eine Signalleiter-Kontaktfläche (13.131 - 13.134) kontaktiert; und dass je einer der Verbindungsleiter (13.21 - 13.24) genau eine Verbindungsleiter-Kontaktfläche (13.141 - 13.144) kontaktiert.

4. Piezoelektrischer Beschleunigungsaufnehmer (1) nach einem der Ansprüche 2 oder 3, **dadurch gekennzeichnet, dass** die Elektroden (11.21 - 11.24) mindestens eine erste Elektrode (11.21 - 11.23) und mindestens eine weitere Elektrode (11.24) aufweisen; dass die erste Elektrode (11.21 - 11.23) mindestens ein erstes Signal (S1 - S3) liefert und dass die weitere Elektrode (11.24) mindestens ein weiteres Signal (S4) liefert; dass die Aufnehmereinheit (11) mindestens eine erste Aufnehmereinheit-Kontaktfläche (11.81 - 11.83) aufweist, an denen das erste Signal (S1 - S3) anliegt und dass die Aufnehmereinheit (11) mindestens eine weitere Aufnehmereinheit-Kontaktfläche (11.84) aufweist, an denen das weitere Signal (S4) anliegt; dass die Verbindungsleiter (13.21 - 13.24) mindestens einen ersten Verbindungsleiter (13.21 - 13.23) und einen mindestens einen weiteren Verbindungsleiter (13.24) aufweisen; dass die Leiterbahnen (13.121 - 13.124) mindestens eine erste Leiterbahn (13.121 - 13.123) und mindestens eine weitere Leiterbahn (13.124) aufweisen; dass der erste Verbindungsleiter (13.21 - 13.23) genau die erste Aufnehmereinheit-Kontaktfläche (11.81 - 11.83) und die erste Leiterbahn (13.121 - 13.124) kontaktiert und das erste Signal (S1 - S3) ableitet; und dass der weitere Verbindungsleiter (13.24) genau die weitere Aufnehmereinheit-Kontaktfläche (11.84) und genau die weitere Leiterbahn (13.124) kontaktiert und das weitere Signal (S4) ableitet.

5. Piezoelektrischer Beschleunigungsaufnehmer (1) nach Anspruch 4, **dadurch gekennzeichnet, dass** die Signalleiter (14.11 - 14.14) mindestens einen ersten Signalleiter (14.11 - 14.13) und mindestens einen weiteren Signalleiter (14.14) aufweisen; dass der erste Signalleiter (14.11 - 14.13) genau eine erste Leiterbahn (13.121 - 13.123) kontaktiert und das erste Signal (S1 - S3) ableitet; und dass der weitere Signalleiter (14.14) genau die weitere Leiterbahn (13.124) kontaktiert und das weitere Signal (S4) ableitet.

6. Piezoelektrischer Beschleunigungsaufnehmer (1) nach einem der Ansprüche 1 bis 5, **dadurch gekennzeichnet, dass** das Trägerelement (13.1) einen Körper (13.11) aus elektrisch isolierendem Material aufweist; und dass die Leiterbahnen (13.121 - 13.124) in einer direkt auf dem Körper (13.11) aufgebrachten elektrisch leitfähigen Dünnschicht strukturiert sind.

7. Piezoelektrischer Beschleunigungsaufnehmer (1) nach Anspruch 6, **dadurch gekennzeichnet, dass** jede Leiterbahn (13.121 - 13.124) genau eine Signalleiter-Kontaktfläche (13.131 - 13.134) und genau eine Verbindungsleiter-Kontaktfläche (13.141 - 13.144) aufweist; dass das Trägerelement (13.1) eine erste Stirnfläche (13.111) und eine weitere Stirnfläche (13.112) aufweist; dass die Signalleiter-Kontaktflächen (13.131 - 13.134) auf der ersten Stirnfläche (13.111) und auf der weiteren Stirnfläche (13.112) angeordnet sind; und dass die Verbindungsleiter-Kontaktflächen (13.141 - 13.144) auf der ersten Stirnfläche (13.111) angeordnet sind.

8. Piezoelektrischer Beschleunigungsaufnehmer (1) nach Anspruch 7, **dadurch gekennzeichnet, dass** die Signaldurchführung (13) eine Signaldurchführungswand (13.3) und eine Vergussmasse (13.5) aufweist, welche Signaldurchführungswand (13.3) eine Signalleiteröffnung (13.4) aufweist; dass das Trägerelement (13.1) in der Signalleiteröffnung (13.4) haltend eingesetzt ist; dass Enden der Signalleiter (14.11 - 14.14) durch die Signalleiteröffnung (13.4) ragen; und dass die Vergussmasse (13.5) auf die Signalleiter (14.11 - 14.14) in der Signalleiteröffnung (13.4) aufgebracht ist und das haltend in der Signaldurchführungswand (13.3) eingesetzte Trägerelement (13.1) mechanisch absichert und die Signalleiteröffnung (13.4) wasser- und gasdicht verschliesst.

9. Piezoelektrischer Beschleunigungsaufnehmer (1) nach Anspruch 6, **dadurch gekennzeichnet, dass** jede Leiterbahn (13.121 - 13.124) genau eine Signalleiter-Kontaktfläche (13.131 - 13.134) und genau eine Verbindungsleiter-Kontaktfläche (13.141 - 13.144) aufweist; dass das Trägerelement (13.1) eine erste Stirnfläche (13.111), eine Mantelfläche (13.113) und eine Durchgangsöffnung (13.4') mit einer Innenfläche (13.114) aufweist; dass die Signalleiter-Kontaktflächen (13.131 - 13.134) auf der Innenfläche (13.114) angeordnet sind; und dass die Verbindungsleiter-Kontaktflächen (13.141 - 13.144) auf der Mantelfläche (13.113) angeordnet sind.

10. Piezoelektrischer Beschleunigungsaufnehmer (1) nach Anspruch 9, **dadurch gekennzeichnet, dass** die Signaldurchführung (13) eine Signaldurchführungswand (13.3) und eine Vergussmasse (13.5) aufweist, welche Signaldurchführungswand (13.3) eine Signalleiteröffnung (13.4) aufweist; dass das Trägerelement (13.1) an der Signalleiteröffnung (13.4) befestigt ist; dass die Signalleiteröffnung (13.4) und Durchgangsöffnung (13.4') deckungsgleich sind; dass Enden der Signalleiter (14.11 - 14.14) durch die Signalleiteröffnung (13.4) in die Durchgangsöffnung (13.4') ragen; und dass die Vergussmasse (13.5) auf die Signalleiter (14.11 - 14.14) in der Durchgangsöffnung (13.4') aufgebracht ist und die Durchgangsöffnung (13.4') wasser- und gasdicht verschliesst.

11. Verfahren zur Montage eines piezoelektrischen Beschleunigungsaufnehmers (1) nach einem der Ansprüche 1 bis 8, **dadurch gekennzeichnet, dass** in einem ersten Schritt der Montage eine Signaldurchführung (13) mit einer Signaldurchführungswand (13.3) und ein Signalkabel (14) mit mindestens zwei Signalleitern (14.11 - 14.14) bereitgestellt werden, welche Signaldurchführungswand (13.3) eine Signalleiteröffnung (13.4) aufweist; dass die Signalleiter (14.11 - 14.14) von der Umgebung (0) her durch die Signalleiteröffnung (13.4) geschoben werden und Enden der Signalleiter (14.11 - 14.14) durch die Signalleiteröffnung (13.4) ragen; dass in einem zweiten Schritt der Montage ein Trägerelement (13.1) mit zwei Stirnflächen (13.111, 13.112) bereitgestellt wird, welche Stirnflächen (13.111, 13.112) mindestens zwei Leiterbahnen (13.121 - 13.124) aufweisen, welche Leiterbahnen (13.121 - 13.124) in Signalleiter-Kontaktflächen (13.131 - 13.134) enden; dass das Trägerelement (13.1) so an der Signalleiteröffnung (13.4) ausgerichtet wird, dass die Enden der Signalleiter (14.11 - 14.14) an den Stirnflächen (13.111, 13.112) zu liegen kommen; und dass die Enden der Signalleiter (14.11 - 14.14) mit den Signalleiter-Kontaktflächen (13.131 - 13.134) kontaktiert werden.

12. Verfahren nach Anspruch 11, **dadurch gekennzeichnet, dass** die Signaldurchführungswand (13.3) mindestens ein Halteelement (13.31, 13.32) aufweist und dass das Trägerelement (13.1) mindestens ein Führungselement (13.151, 13.152) aufweist und dass in einem dritten Schritt der Montage das Trägerelement (13.1) über das Führungselement (13.151, 13.152) und das Halteelement (13.31, 13.32) haltend in der Signaldurchführungswand (13.3) eingesetzt wird; dass in einem vierten Schritt der Montage die mit den Signalleiter-Kontaktflächen (13.131 - 13.134) kontaktierten Signalleiter (14.11 - 14.14) mit Vergussmasse (13.5) vergossen werden; und dass die Vergussmasse (13.5) ausgehärtet und/oder abgebunden wird und die Signalleiteröffnung (13.4) wasser- und gasdicht verschlossen wird; und dass die Vergussmasse (13.5) bereichsweise auf das Trägerelement (13.1) und die Signaldurchführungswand (13.3) aufgebracht wird und das haltend in der Signaldurchführungswand (13.3) eingesetzte Trägerelement (13.1) mechanisch abgesichert wird.

13. Verfahren nach Anspruch 12, **dadurch gekennzeichnet, dass** in einem fünften Schritt der Montage Teile des Gehäuses (12) bereitgestellt werden, welche Teile des Gehäuses (12) mit der Signaldurchführungswand (13.3) mechanisch stabil verbunden werden, welche mechanisch stabil mit der Signaldurchführungswand (13.3) verbundenen Teile des Gehäuses (12) ein Gehäuseinneres (12.0) bilden; dass in einem sechsten Schritt der Montage ein Aufnehmerelement (11) bereitgestellt wird, welches Aufnehmereinheit (11) in das Gehäuseinnere (12.0) gesetzt und am Gehäuse (12) befestigt wird; dass in einem siebten Schritt der Montage mindestens zwei Verbindungsleiter (13.21 - 13.24) bereitgestellt werden; dass die Aufnehmereinheit (11) mindestens zwei Aufnehmereinheit-Kontaktflächen (11.81 - 11.84) aufweist und dass je einer der Verbindungsleiter (13.21 - 13.24) mit genau einer der Aufnehmereinheit-Kontaktflächen (11.81 - 11.84) kontaktiert wird; und dass je einer der Verbindungsleiter (13.21 - 13.24) mit genau einer der Leiterbahnen (13.121 - 13.124) kontaktiert wird.

14. Verfahren zur Montage eines piezoelektrischen Beschleunigungsaufnehmers (1) nach einem der Ansprüche 1 bis 6 und 9 bis 10, **dadurch gekennzeichnet, dass** in einem ersten Schritt der Montage Teile eines Gehäuses (12), einer Signaldurchführung (13) mit einer Signaldurchführungswand (13.3) und ein Trägerelement (13.1) mit einer ersten Stirnfläche (13.111), einer Mantelfläche (13.113) und einer Durchgangsöffnung (13.4') mit einer Innenfläche (13.114) bereitgestellt werden, welche Signaldurchführungswand (13.3) eine Signalleiteröffnung (13.4) aufweist; dass in einem zweiten Schritt der Montage die Teile des Gehäuses (12) mit der Signaldurchführungswand (13.3) mechanisch stabil verbunden werden, welche mechanisch stabil mit der Signaldurchführungswand (13.3) verbundenen Teile des Gehäuses (12) ein Gehäuseinneres (12.0) bilden; dass die erste Stirnfläche (13.111) mindestens zwei Leiterbahnen (13.121 - 13.124) aufweist, welche Leiterbahnen (13.121 - 13.124) in Signalleiter-Kontaktflächen (13.131 - 13.134) enden, welche Signalleiter-Kontaktflächen (13.131 - 13.134) auf der Innenfläche (13.114) angeordnet sind; dass im zweiten Schritt der Montage das Trägerelement (13.1) so an der Signalleiteröffnung (13.4) befestigt wird, dass die Signalleiteröffnung (13.4) und Durchgangsöffnung (13.4') deckungsgleich sind; dass in einem dritten Schritt der Montage ein Signalkabel (14) mit mindestens zwei Signalleitern (14.11 - 14.14) bereitgestellt wird; dass die Signalleiter (14.11 - 14.14) von der Umgebung (0) her durch die Signalleiteröffnung (13.4) und die Durchgangsöffnung (13.4') geschoben werden und Enden der Signalleiter (14.11 - 14.14) durch die Signalleiteröffnung (13.4) in die Durchgangsöffnung (13.4') ragen und an den Stirnflächen (13.111, 13.112) zu liegen kommen; dass in einem vierten Schritt der Montage die Enden der Signalleiter (14.11 - 14.14) mit den Signalleiter-Kontaktflächen (13.131 - 13.134) kontaktiert werden.

15. Verfahren nach Anspruch 14, **dadurch gekennzeichnet, dass** in einem vierten Schritt der Montage die mit den Signalleiter-Kontaktflächen (13.131 - 13.134) kontaktierten Signalleiter (14.11 - 14.14) mit Vergussmasse (13.5) vergossen werden; und dass die Vergussmasse (13.5) ausgehärtet und/oder abgebunden wird und die Durchgangsöffnung (13.4') wasser- und gasdicht verschlossen wird; dass in einem sechsten Schritt der Montage ein Aufnehmerelement (11) bereitgestellt wird, welches Aufnehmereinheit (11) in das Gehäuseinnere (12.0) gesetzt und am Gehäuse (12) befestigt wird; dass in einem siebten Schritt der Montage mindestens zwei Verbindungsleiter (13.21 - 13.24) bereitgestellt werden; dass die Aufnehmereinheit (11) mindestens zwei Aufnehmereinheit-Kontaktflächen (11.81 - 11.84) aufweist und dass je einer der Verbindungsleiter (13.21 - 13.24) mit genau einer der Aufnehmereinheit-Kontaktflächen (11.81 - 11.84) kontaktiert wird; und dass je einer der Verbindungsleiter (13.21 - 13.24) mit genau einer der Leiterbahnen (13.121 - 13.124) kontaktiert wird.

## Claims

1. A piezoelectric acceleration transducer (1) for measuring an acceleration; that comprises a transducer unit (11) comprising at least one piezoelectric element (11.11 - 11.13) and at least two electrodes (11.21 - 11.26), wherein said piezoelectric element (11.11 - 11.13) is made of a piezoelectric material and generates polarization charges under the influence of the acceleration, wherein said electrodes (11.21 - 11.26) directly contact the piezoelectric element (11.11 - 11.13) in specific areas and pick up the polarization charges; that comprises a housing (12) which encloses the transducer unit (11) in a water-tight and gas-tight manner; and that comprises a signal lead-through (13) electrically connected to the electrodes (11.21 - 11.26) and transmitting the polarization charges as signals (S1 - S4) through the housing (12) to an environment (0) outside of the housing (12); wherein said piezoelectric acceleration transducer (1) comprises a signal cable (14) located in the environment (0) outside of the housing (12) and comprising at least two signal conductors (14.11 - 14.14); **characterized in that** said signal lead-through (13) comprises a support element (13.1), on which support element (13.1) are arranged at least two conducting paths (13.121 - 13.124); and **in that** each of the signal conductors (14.11 - 14.14) makes a contact with exactly one of said conducting paths (13.121 - 13.124).

2. The piezoelectric acceleration transducer (1) according to claim 1, **characterized in that** the signal lead-through (13) comprises at least two connecting conductors (13.21 - 13.24); **in that** the transducer unit (11) comprises at least two transducer unit contact surfaces (11.81 - 11. 84) to which the signals (S1 - S4) are applied; **in that** each of the connecting conductors (13.21 - 13.24) makes a contact with exactly one of the transducer unit contact surfaces (11.81 - 11.84); and **in that** each of the connecting conductors (13.21 - 13.24) makes a contact with exactly one of the conducting paths (13.121 - 13.124).

3. The piezoelectric acceleration transducer (1) according to claim 2, **characterized in that** each conducting path (13.121 - 13.124) comprises exactly one signal conductor contact surface (13.131 - 13.134) and exactly one connecting conductor contact surface (13.141 - 13.144); **in that** each of the signal conductors (14.11 - 14.14) makes a contact with exactly one signal conductor contact surface (13.131 - 13.134); and **in that** each of the connecting conductors (13.21 - 13.24) makes a contact with exactly one connecting conductor contact surface (13.141 - 13.144).

4. The piezoelectric acceleration transducer (1) according to any of the claims 2 or 3, **characterized in that** the electrodes (11.21 - 11.24) comprise at least one first electrode (11.21 - 11.23) and at least one further electrode (11.24); **in that** the first electrode (11.21 - 11.23) provides at least one first signal (S1 - S3), and **in that** the further electrode (11. 24) provides at least one further signal (S4); **in that** the transducer unit (11) comprises at least one first transducer unit contact surface (11.81 - 11.83) to which the first signal (S1 - S3) is applied, and **in that** the transducer unit (11) comprises at least one further transducer unit contact surface (11.84) to which the further signal (S4) is applied; **in that** the connecting conductors (13. 21 - 13.24) comprise at least one first connecting conductor (13.21 - 13.23) and at least one further connecting conductor (13.24); **in that** the conducting paths (13.121 - 13.124) comprise at least one first conducting path (13.121 - 13.123) and at least one further conducting path (13.124); **in that** the first connecting conductor (13.21 - 13.23) makes a contact with exactly said first transducer unit contact surface (11.81 - 11.83) and said first conducting path (13.121 - 13.124) and transmits said first signal (S1 - S3); and **in that** the further connecting conductor (13.24) makes a contact with exactly said further transducer unit contact surface (11.84) and exactly said further conducting path (13.124) and transmits said further signal (S4).

5. The piezoelectric acceleration transducer (1) according to claim 4, **characterized in that** the signal conductors (14.11 - 14.14) comprise at least one first signal conductor (14.11 - 14.13) and at least one further signal conductor (14.14); **in that** the first signal conductor (14. 11 - 14.13) exactly makes a contact with a first conducting path (13.121 - 13.123) and transmits the first signal (S1 - S3); and **in that** the further signal conductor (14.14) exactly makes a contact with the further conducting path (13.124) and transmits the further signal (S4).

6. The piezoelectric acceleration transducer (1) according to any of the claims 1 to 5, **characterized in that** the support element (13.1) comprises a body (13.11) made of electrically insulating material; and **in that** the conducting paths (13.121 - 13.124) are patterned in an electrically conductive thin film applied directly to the body (13.11).

7. The piezoelectric acceleration transducer (1) according to claim 6, **characterized in that** each conducting path (13.121 - 13.124) comprises exactly one signal conductor contact surface (13.131 - 13.134) and exactly one connecting conductor contact surface (13.141 - 13.144); **in that** the support element (13.1) comprises a first end face (13. 111) and a further end face (13.112); **in that** the signal conductor contact surfaces (13.131 - 13.134) are arranged on the first end face (13.111) and on the further end face (13.112); and **in that** the connecting conductor contact surfaces (13.141 - 13.144) are arranged on the first end face (13.111).

8. The piezoelectric acceleration transducer (1) according to claim 7, **characterized in that** the signal lead-through (13) comprises signal lead-through wall (13.3) and a casting compound (13.5), which signal lead-through wall (13.3) has a signal conductor opening (13.4); **in that** the support element (13.1) is inserted in a holding manner in the signal conductor opening (13.4); **in that** ends of the signal conductors (14.11 - 14.14) protrude through the signal conductor opening (13. 4); and **in that** the casting compound (13.5) is applied to the signal conductors (14.11 - 14.14) in the signal conductor opening (13.4) and mechanically secures the support element (13.1) inserted in the signal lead-through wall (13.3) in a holding manner and seals the signal conductor opening (13.4) in a water-tight and gas-tight manner.

9. The piezoelectric acceleration transducer (1) according to claim 6, **characterized in that** each conductor path (13.121 - 13.124) comprises precisely one signal conductor contact surface (13.131 - 13.134) and precisely one connecting conductor contact surface (13.141 - 13.144); **in that** the support element (13.1) comprises a first end face (13.111), a lateral surface (13.113) and a through opening (13.4') comprising an inner surface (13.114); **in that** the signal conductor contact surfaces (13.131 - 13.134) are arranged on said inner surface (13.114); and **in that** the connecting conductor contact surfaces (13.141 - 13.144) are arranged on said lateral surface (13.113).

10. The piezoelectric acceleration transducer (1) according to claim 9, **characterized in that** the signal lead-through (13) comprises a signal lead-through wall (13.3) and a casting compound (13.5), which signal lead-through wall (13.3) has a signal conductor opening (13.4); **in that** the support element (13.1) is attached to the signal conductor opening (13.4); **in that** the signal conductor opening (13.4) and the through-opening (13.4') coincide with each other; **in that** ends of the signal conductors (14.11 - 14.14) protrude through the signal conductor opening (13.4) into the through-opening (13.4'); and **in that** the casting compound (13.5) is applied to the signal conductors (14.11 - 14.14) in the through-opening (13.4') and seals the through-opening (13.4') in a water-tight and gas-tight manner.

11. A procedure for the assembly of a piezoelectric acceleration transducer (1) according to any of the claims 1 to 8, **characterized in that** in a first step of the assembly is provided a signal lead-through (13) comprising a signal lead-through wall (13.3) and a signal cable (14) comprising at least two signal conductors (14.11 - 14.14), which signal lead-through wall (13.3) comprises a signal conductor opening (13.4), **in that** the signal conductors (14.11 - 14.14) are inserted from the side of the environment (0) through the signal conductor opening (13.4) and wherein ends of the signal conductors (14.11 - 14.14) protrude through the signal conductor opening (13.4); **in that** in a second step of the assembly a support element (13.1) having two end faces (13.111, 13.112) is provided, which end faces (13.111, 13.112) comprise at least two conducting paths (13.121 - 13.124), which conducting paths (13.121 - 13.124) terminate in signal conductor contact surfaces (13.131 - 13.134); **in that** the support element (13.1) is arranged in the signal conductor opening (13.4) in such a way that the ends of the signal conductors (14.11 - 14.14) protrude onto the end faces (13.111, 13.112); and **in that** the ends of the signal conductors (14.11 - 14.14) are connected with the signal conductor contact surfaces (13.131 - 13.134).

12. The procedure according to claim 11, **characterized in that** the signal lead-through wall (13.3) comprises at least one holding element (13.31, 13.32) and **in that** the support element (13.1) comprises at least one guiding element (13.151, 13.152), and **in that** in a third step of the assembly the support element (13. 1) is inserted in a retaining manner in the signal lead-through wall (13.3) by the guiding element (13.151, 13.152) and the holding element (13.31, 13.32); **in that** in a fourth step of the assembly the signal conductor contact surfaces (13.131 - 13.134) are cast with casting compound (13.5); and **in that** the casting compound (13.5) is cured and/or set and the signal conductor opening (13.4) is closed in a water-tight and gas-tight manner; and **in that** the casting compound (13. 5) is applied to the support element (13.1) and the signal lead-through wall (13.3) in specific areas and the support element (13.1) inserted in the signal lead-through wall (13.3) in a retaining manner is mechanically secured.

13. The procedure according to claim 12, **characterized in that** in a fifth step of the assembly parts of the housing (12) are provided, which parts of the housing (12) are connected to the signal lead-through wall (13.3) in a mechanically stable manner, which parts of the housing (12) that are connected to the signal lead-through wall (13.3) in a mechanically stable manner form a housing interior (12.0); **in that** in a sixth step of the assembly a transducer element (11) is provided, which transducer element (11) is inserted in the housing interior (12.0) and secured to the housing (12); that in a seventh step of the assembly at least two connecting conductors (13.21 - 13.24) are provided; that the transducer unit (11) comprises at least two transducer unit contact surfaces (11.81 - 11. 84) and **in that** each of said connecting conductors (13.21 - 13.24) is connected with exactly one of the transducer unit contact surfaces (11.81 - 11.84); and **in that** each of said connecting conductors (13.21 - 13.24) is connected with exactly one of the conducting paths (13.121 - 13.124).

14. The procedure for the assembly of a piezoelectric acceleration transducer (1) according to any of the claims 1 to 6 and 9 to 10, **characterized in that** in a first step of the assembly parts of a housing (12), a signal lead-through (13) comprising a signal lead-through wall (13.3) and a support element (13.1) comprising a first end face (13.111), a lateral surface (13.113) and a through-opening (13.4') comprising an inner surface (13.114) are provided, which signal lead-through wall (13.3) has a signal conductor opening (13.4); **in that** in a second step of the assembly the parts of the housing (12) are attached to the signal lead-through wall (13.3) in a mechanically stable manner, which parts of the housing (12) attached to the signal lead-through wall (13.3) in a mechanically stable manner define a housing interior (12.0); **in that** said first end face (13.111) comprises at least two conductor paths (13.121 - 13.124), which conductor paths (13.121 - 13.124) terminate in signal conductor contact surfaces (13.131 - 13.134), which signal conductor contact surfaces (13.131 - 13.134) are arranged on said inner surface (13.114); **in that** in the second step of the assembly the support element (13.1) is secured to the signal conductor opening (13.4) in such a way that the signal conductor opening (13.4) and the through opening (13.4') coincide with each other; **in that** in a third step of the assembly a signal cable (14) comprising at least two signal conductors (14.11 - 14.14) is provided; **in that** said signal conductors (14. 11 - 14.14) are inserted from the side of the environment (0) through the signal conductor opening (13.4) and the through opening (13.4') and wherein ends of the signal conductors (14.11 - 14.14) protrude through the signal conductor opening (13.4) into the through opening (13.4') and protrude onto the end faces (13.111, 13.112); **in that** in a fourth step of the assembly contacts are established between the ends of the signal conductors (14.11 - 14.14) and the signal conductor contact surfaces (13.131 - 13.134).

15. The procedure according to claim 14, **characterized in that** in a fourth step of the assembly the signal conductors (14.11 - 14.14) in contact with the signal conductor contact surfaces (13.131 - 13.134) are cast with casting compound (13.5); and **in that** the casting compound (13. 5) is cured and/or set and the through opening (13.4) is sealed in a water-tight and gas-tight manner; **in that** in a sixth step of the assembly a transducer element (11) is provided, which transducer unit (11) is introduced in the housing interior (12. 0) and secured to the housing (12); **in that** in a seventh step of the assembly at least two connecting conductors (13.21 - 13.24) are provided; **in that** the transducer unit (11) comprises at least two transducer unit contact surfaces (11.81 - 11.84) and **in that** a contact is established of each one of the connecting conductors (13.21 - 13.24) with exactly one of the transducer unit contact surfaces (11.81 - 11.84); and **in that** a contact is established of each one of the connecting conductors (13.21 - 13.24) with exactly one of the conductor paths (13.121 - 13.124).

## Revendications

1. Capteur d'accélération piézoélectrique (1) pour mesurer une accélération ; comprenant une unité de capteur (11) comportant au moins un élément piézo (11.11 - 11.13) et au moins deux électrodes (11.21 - 11.26), dans lequel ledit élément piézo (11.11 - 11.13) est d'un matériau piézoélectrique et génère des charges de polarisation sous l'action de l'accélération, lesdites électrodes (11.21 - 11.26) sont en contact direct avec l'élément piézoélectrique (11.11 - 11.13) localement et prélèvent lesdites charges de polarisation ; comprenant un boîtier (12) qui renferme l'unité de capteur (11) de manière étanche à l'eau et au gaz ; et comprenant un dispositif de traversée de signal (13) qui est connecté électriquement aux électrodes (11.21 - 11.26) et transmet les charges de polarisation en tant que signaux (S1 - S4) à travers le boîtier (12) vers un environnement (0) à l'extérieur du boîtier (12) ; dans lequel ledit capteur d'accélération piézoélectrique (1) comprend un câble de signal (14) situé dans l'environnement (0) à l'extérieur du boîtier (12) et comprenant au moins deux conducteurs de signal (14.11 - 14.14) ; **caractérisé en ce que** ledit dispositif de traversée de signal (13) comprend un élément de support (13.1), sur lequel élément de support (13.1) sont disposés au moins deux pistes conductrices (13.121 - 13.124) ; et **en ce que** chacun des conducteurs de signal (14.11 - 14.14) entre en contact avec exactement une desdites pistes conductrices (13.121 - 13.124) .

2. Capteur d'accélération piézoélectrique (1) selon la revendication 1, **caractérisé en ce que** le dispositif de traversée de signal (13) comprend au moins deux conducteurs de connexion (13.21 - 13.24) ; **en ce que** l'unité de capteur (11) comprend au moins deux surfaces de contact de l'unité de capteur (11.81 - 11.84) auxquelles les signaux (S1 - S4) sont appliqués ; **en ce que** chacun des conducteurs de connexion (13.21 - 13.24) est en contact avec exactement une des surfaces de contact de l'unité de capteur (11.81 - 11.84) ; et **en ce que** chacun des conducteurs de connexion (13.21 - 13.24) est en contact avec exactement une des pistes conductrices (13.121 - 13.124).

3. Capteur d'accélération piézoélectrique (1) selon la revendication 2, **caractérisé en ce que** chaque piste conductrice (13.121 - 13.124) comporte exactement une surface de contact de conducteur de signal (13.131 - 13.134) et exactement une surface de contact de conducteur de connexion (13.141 - 13. 144) ; **en ce que** chacun des conducteurs de signal (14.11 - 14.14) est en contact avec exactement une surface de contact de conducteur de signal (13.131 - 13.134) ; et **en ce que** chacun des conducteurs de connexion (13.21 - 13.24) est en contact avec exactement une surface de contact de conducteur de connexion (13.141 - 13.144).

4. Capteur d'accélération piézoélectrique (1) selon l'une quelconque des revendications 2 ou 3, **caractérisé en ce que** les électrodes (11.21 - 11.24) comprennent au moins une première électrode (11.21 - 11.23) et au moins une autre électrode (11.24) ; **en ce que** la première électrode (11.21 - 11.23) fournit au moins un premier signal (S1 - S3) et **en ce que** l'autre électrode (11.24) fournit au moins un autre signal (S4) ; **en ce que** l'unité de capteur (11) comprend au moins une première surface de contact de l'unité de capteur (11.81 - 11.83) auxquelles le premier signal (S1 - S3) est appliqué, et **en ce que** l'unité de capteur (11) comprend au moins une autre surface de contact de l'unité de capteur (11.84) auxquelles l'autre signal (S4) est appliqué ; **en ce que** les conducteurs de connexion (13.21 - 13.24) comprennent au moins un premier conducteur de connexion (13.21 - 13.23) et au moins un autre conducteur de connexion (13.24) ; **en ce que** les pistes conductrices (13.121 - 13.124) comprennent au moins une première piste conductrice (13.121 - 13.123) et au moins une autre piste conductrice (13.124) ; **en ce que** le premier conducteur de connexion (13.21 - 13.23) est en contact avec exactement ladite première surface de contact de l'unité de capteur (11.81 - 11.83) et ladite première piste conductrice (13.121 - 13.124) et transmet ledit premier signal (S1 - S3) ; et **en ce que** l'autre conducteur de connexion (13.24) est en contact avec exactement l'autre surface de contact de l'unité de capteur (11.84) et avec exactement l'autre piste conductrice (13.124) et transmet l'autre signal (S4) .

5. Capteur d'accélération piézoélectrique (1) selon la revendication 4, **caractérisé en ce que** les conducteurs de signal (14.11 - 14.14) comprennent au moins un premier conducteur de signal (14.11 - 14.13) et au moins un autre conducteur de signal (14.14) ; **en ce que** le premier conducteur de signal (14.11 - 14.13) est en contact avec exactement une première piste conductrice (13.121 - 13.123) et transmet le premier signal (S1 - S3) ; et **en ce que** l'autre conducteur de signal (14.14) est en contact avec exactement l'autre piste conductrice (13.124) et transmet l'autre signal (S4).

6. Capteur d'accélération piézoélectrique (1) selon l'une quelconque des revendications 1 à 5, **caractérisé en ce que** l'élément de support (13.1) comprend un corps (13.11) en matériau électriquement isolant ; et **en ce que** les pistes conductrices (13.121 - 13.124) sont gravées dans une couche mince électriquement conductrice disposée directement sur le corps (13.11).

7. Capteur d'accélération piézoélectrique (1) selon la revendication 6, **caractérisé en ce que** chaque piste conductrice (13.121 - 13.124) comprend exactement une surface de contact de conducteur de signal (13.131 - 13.134) et exactement une surface de contact de conducteur de connexion (13.141 - 13.144) ; **en ce que** l'élément de support (13. 1) comprend une première face d'extrémité (13.111) et une autre face d'extrémité (13.112) ; **en ce que** les surfaces de contact de conducteur de signal (13.131 - 13.134) sont agencées sur la première face d'extrémité (13.111) et sur l'autre face d'extrémité (13.112) ; et **en ce que** les surfaces de contact de conducteur de connexion (13.141 - 13.144) sont agencées sur la première face d'extrémité (13.111).

8. Capteur d'accélération piézoélectrique (1) selon la revendication 7, **caractérisé en ce que** le dispositif de traversée de signal (13) comprend une paroi de traversée de signal (13.3) et une masse de coulée (13.5) ; ladite paroi de traversée de signal (13.3) comporte une ouverture pour conducteur de signal (13.4) ; **en ce que** l'élément de support (13.1) est inséré dans l'ouverture pour conducteur de signal (13.4) de manière à y être retenu ; **en ce que** les extrémités des conducteurs de signal (14.11 - 14.14) font saillie à travers l'ouverture pour conducteur de signal (13.4) ; et **en ce que** la masse de coulée (13.5) est appliqué sur les conducteurs de signal (14.11 - 14.14) dans l'ouverture pour conducteur de signal (13.4) et fixe mécaniquement l'élément de support (13.1) inséré dans la paroi de traversée de signal (13.3) de manière à y être retenu et scelle l'ouverture pour conducteur de signal (13.4) de manière étanche à l'eau et au gaz.

9. Capteur d'accélération piézoélectrique (1) selon la revendication 6, **caractérisé en ce que** chaque piste conductrice (13.121 - 13.124) comporte exactement une surface de contact de conducteur de signal (13.131 - 13.134) et exactement une surface de contact de conducteur de connexion (13.141 - 13.144) ; **en ce que** l'élément de support (13.1) comprend une première face d'extrémité (13.111), une surface latérale (13.113) et une ouverture de traversée (13.4') avec une surface intérieure (13.114) ; **en ce que** les surfaces de contact de conducteur de signal (13.131 - 13.134) sont agencées sur ladite surface intérieure (13.114) ; et **en ce que** les surfaces de contact de conducteur de connexion (13.141 - 13.144) sont agencées sur la surface latérale (13.113).

10. Capteur d'accélération piézoélectrique (1) selon la revendication 9, **caractérisé en ce que** le dispositif de traversée de signal (13) comprend une paroi de traversée de signal (13.3) et une masse de coulée (13.5) ; ladite paroi de traversée de signal (13.3) comporte une ouverture pour conducteur de signal (13.4) ; **en ce que** l'élément de support (13.1) est fixé à l'ouverture pour conducteur de signal (13.4) ; **en ce que** l'ouverture pour conducteur de signal (13.4) et l'ouverture de traversée (13.4') sont coïncidents l'une avec l'autre ; **en ce que** les extrémités des conducteurs de signal (14.11 - 14.14) font saillie à travers l'ouverture pour conducteur de signal (13.4) dans l'ouverture de traversée (13.4') ; et **en ce que** la masse de coulée (13.5) est appliquée sur les conducteurs de signal (14.11 - 14.14) dans l'ouverture de traversée (13.4') et scelle l'ouverture de traversée (13.4') de manière étanche à l'eau et au gaz.

11. Procédé pour l'assemblage d'un capteur d'accélération piézoélectrique (1) selon l'une quelconque des revendications 1 à 8, **caractérisé en ce que** dans une première étape de l'assemblage on dispose d'un dispositif de traversée de signal (13) comprenant une paroi de traversée de signal (13.3) et un câble de signal (14) avec au moins deux conducteurs de signal (14.11 - 14.14), dans lequel laquelle paroi de traversée de signal (13.3) comprend une ouverture pour conducteur de signal (13.4) ; **en ce que** les conducteurs de signal (14.11 - 14.14) sont insérés depuis le côté de l'environnement (0) à travers l'ouverture pour conducteur de signal (13.4) et les extrémités des conducteurs de signal (14.11 - 14.14) font saillie à travers l'ouverture pour conducteur de signal (13. 4) ; **en ce que** dans une deuxième étape de l'assemblage on dispose d'un élément de support (13.1) ayant deux faces d'extrémité (13.111, 13.112), lesquelles faces d'extrémité (13.111, 13.112) comprennent au moins deux pistes conductrices (13.121 - 13.124), lesquelles pistes conductrices (13.121 - 13.124) se terminent par des surfaces de contact de conducteur de signal (13.131 - 13.134) ; **en ce que** l'élément de support (13.1) est agencé à l'ouverture pour conducteur de signal (13.4) de telle sorte que les extrémités des conducteurs de signal (14.11 - 14.14) se situent aux faces d'extrémité (13.111, 13.112) ; et **en ce que** les extrémités des conducteurs de signal (14.11 - 14.14) sont contactées par les surfaces de contact de conducteur de signal (13.131 - 13.134) .

12. Procédé selon la revendication 11, **caractérisé en ce que** la paroi de traversée de signal (13.3) comprend au moins un élément de retenue (13.31, 13.32) et **en ce que** l'élément de support (13.1) comprend au moins un élément de guidage (13.151, 13.152) et **en ce que** dans une troisième étape de l'assemblage l'élément de support (13.1) est inséré via l'élément de guidage (13.151, 13.152) et l'élément de retenue (13.31, 13.32) dans la paroi de traversée de signal (13.3) de manière à y être retenu ; **en ce que** dans une quatrième étape de l'assemblage les conducteurs de signal (14.11 - 14.14) contactés par les surfaces de contact de conducteur de signal (13.131 - 13.134) sont coulés avec de la masse à couler (13.5) et **en ce que** la masse à couler (13.5) est durcie et/ou prise et l'ouverture pour conducteur de signal (13.4) est fermée de manière étanche à l'eau et au gaz ; et **en ce que** la masse à couler (13.5) est appliquée localement sur l'élément de support (13.1) et la paroi de traversée de signal (13.3) et l'élément de support (13.1) inséré dans la paroi de traversée de signal (13.3) de manière à y être retenu est fixé mécaniquement.

13. Procédé selon la revendication 12, **caractérisé en ce que** dans une cinquième étape de l'assemblage on dispose des parties du boîtier (12), lesquelles parties du boîtier (12) sont reliées à la paroi de traversée de signal (13.3) de manière mécaniquement stable, lesquelles parties du boîtier (12) reliées à la paroi de traversée de signal (13.3) de manière mécaniquement stable définissent un intérieur de boîtier (12.0) ; **en ce que** dans une sixième étape de l'assemblage on dispose d'un élément capteur (11), laquelle unité de capteur (11) est insérée dans l'intérieur de boîtier (12.0) et fixée au boîtier (12) ; **en ce que** dans une septième étape de l'assemblage on dispose d'au moins deux conducteurs de connexion (13.21 - 13.24) ; **en ce que** l'unité de capteur (11) comprend au moins deux surfaces de contact de l'unité de capteur (11.81 - 11.84) et **en ce que** chacun des conducteurs de connexion (13.21 - 13.24) est contacté avec exactement une des surfaces de contact de l'unité de capteur (11.81 - 11.84) ; et **en ce que** chacun des conducteurs de connexion (13.21 - 13.24) est contacté avec exactement une des pistes conductrices (13.121 - 13.124).

14. Procédé d'assemblage d'un capteur d'accélération piézoélectrique (1) selon l'une quelconque des revendications 1 à 6 et 9 à 10, **caractérisé en ce que** dans une première étape de l'assemblage on dispose des pièces d'un boîtier (12), d'un dispositif de traversée de signal (13) ayant une paroi de traversée de signal (13.3) et d'un élément de support (13.1) ayant une première face d'extrémité (13.111), une surface latérale (13.113) et une ouverture de traversée (13.4') avec une surface intérieure (13.114) ; laquelle paroi de traversée de signal (13.3) comporte une ouverture pour conducteur de signal (13.4) ; **en ce que** dans une deuxième étape de l'assemblage les pièces du boîtier (12) sont reliées à la paroi de traversée de signal (13.3) de manière mécaniquement stable, lesquelles parties du boîtier (12) reliées à la paroi de traversée de signal (13.3) de manière mécaniquement stable définissent un intérieur de boîtier (12.0) ; **en ce que** la première face d'extrémité (13.111) comprend au moins deux pistes conductrices (13.121 - 13.124), lesquelles pistes conductrices (13.121 - 13.124) se terminent par des surfaces de contact de conducteur de signal (13.131 - 13.134), lesquelles surfaces de contact de conducteur de signal (13.131 - 13.134) sont agencées sur ladite surface intérieure (13.114) ; **en ce que** dans la deuxième étape de l'assemblage l'élément de support (13.1) est fixé à l'ouverture pour conducteur de signal (13.4) de telle sorte que l'ouverture pour conducteur de signal (13.4) et l'ouverture de traversée (13.4') coïncident ; **en ce que** dans une troisième étape de l'assemblage on dispose d'un câble de signal (14) avec au moins deux conducteurs de signal (14.11 - 14.14) ; **en ce que** lesdits conducteurs de signal (14.11 - 14.14) sont insérés depuis le côté de l'environnement (0) à travers l'ouverture pour conducteur de signal (13.4) et l'ouverture de traversée (13.4') et les extrémités des conducteurs de signal (14.11 - 14.14) font saillie à travers l'ouverture pour conducteur de signal (13.4) dans l'ouverture de traversée (13.4') et se situent aux faces d'extrémité (13.111, 13.112) ; **en ce que** dans une quatrième étape de l'assemblage les extrémités des conducteurs de signal (14.11 - 14.14) sont contactées avec les surfaces de contact de conducteur de signal (13.131 - 13.134).

15. Procédé selon la revendication 14, **caractérisé en ce que** dans une quatrième étape de l'assemblage les conducteurs de signal (14.11 - 14.14) en contact avec les surfaces de contact de conducteur de signal (13.131 - 13.134) sont coulés avec une masse de coulée (13.5) ; et **en ce que** la masse de coulée (13.5) est durcie et/ou prise et l'ouverture de traversée (13.4') est scellée de manière étanche à l'eau et au gaz ; **en ce que** dans une sixième étape de l'assemblage on dispose d'un élément capteur (11), laquelle unité de capteur (11) est introduite à l'intérieur du boîtier (12.0) et fixée au boîtier (12) ; **en ce que** dans une septième étape de l'assemblage on dispose d'au moins deux conducteurs de connexion (13.21 - 13.24) ; **en ce que** l'unité de capteur (11) comprend au moins deux surfaces de contact de l'unité de capteur (11.81 - 11.84) et **en ce que** chacun des conducteurs de connexion (13.21 - 13.24) est contacté avec exactement une des surfaces de contact de l'unité de capteur (11.81 - 11.84) ; et **en ce que** chacun des conducteurs de connexion (13.21 - 13.24) est contacté avec exactement une des pistes conductrices (13.121 - 13.124).
